# EUROPEAN PATENT SPECIFICATION

(11) **EP 1 670 047 B1**
(45) Date of publication and mention of the grant of the patent: **07.04.2010**
(21) Application number: 04788401.0
(22) Date of filing: 30.09.2004
(51) Int. Cl.: H01L 21/304, B24B 37/00, C09K 3/14, C09G 1/02

(54) **POLISHING COMPOSITION AND POLISHING METHOD**
POLIERZUSAMMENSETZUNG UND POLIERVERFAHREN
COMPOSITION DE POLISSAGE ET PROCEDE DE POLISSAGE

(30) Priority: 30.09.2003 JP 2003342532; 17.10.2003 JP 2003358551
(43) Date of publication of application: 14.06.2006
(73) Proprietor: FUJIMI INCORPORATED, Kiyosu-shi Aichi 452-8502 (JP)
(72) Inventor: MATSUDA, Tsuyoshi, c/o Fujimi Incorporated, Kiyosu-shi Aichi 452-8502 (JP); HIRANO, Tatsuhiko, c/o Fujimi Incorporated, Kiyosu-shi Aichi 452-8502 (JP); OH, Junhui, c/o Fujimi Incorporated, Kiyosu-shi Aichi 452-8502 (JP); KAWAMURA, Atsunori, c/o Fujimi Incorporated, Kiyosu-shi Aichi 452-8502 (JP); SAKAI, Kenji, c/o Fujimi Incorporated, Kiyosu-shi Aichi 452-8502 (JP)
(74) Representative: Behnisch, Werner
(86) International application number: PCT/JP2004/014373
(87) International publication number: WO 2005/031836

(56) References cited:
- JP-A- 11 116 942
- JP-A- 2000 243 730
- JP-A- 2000 252 242
- JP-A- 2003 124 158
- JP-A- 2003 514 374
- US-A1- 2002 151 167
- "Composition for polishing semiconductor, consists of preset amount of abrasives, benzotriazole, tartaric acid, hydrogen peroxide, polyvinyl alcohol and water" DERWENT,, 1 January 1900 (1900-01-01), XP002331705

## Description

### TECHNICAL FIELD

The present invention relates to a polishing composition, for example, for use in polishing for forming wiring in semiconductor devices, and a polishing method for forming wiring in semiconductor devices.

### BACKGROUND ART

A ULSI with high integration and high speed is manufactured according to a fine design rule. In order to inhibit the increase of wiring resistance due to refined wiring in semiconductor devices, in recent years, a copper-containing metal is employed as a wiring material.

Since the copper-containing metal has a property that it is difficult to process by anisotropic etching, the copper-containing metal is treated to form the wiring according to a chemical mechanical polishing (CMP) process as follows. Firstly, a barrier layer made of a tantalum-containing compound is provided on an insulating layer having a trench. Next, a conductive layer made of a copper-containing metal is provided on the barrier layer so as to bury at least the trench. Then, a portion of the conductive layer and a portion of the barrier layer which are both positioned outside the trench are removed by chemical mechanical polishing. Accordingly, a portion of the conductive layer positioned inside the trench is left on the insulating layer, and the portion functions as wiring.

In order to remove the portion of the conductive layer and the portion of the barrier layer which are both positioned outside the trench, the chemical mechanical polishing is usually carried out by two divided steps of a first polishing step and a second polishing step. Firstly, in the first polishing step, the chemical mechanical polishing removes one part of the portion of the conductive layer positioned outside the trench in order to expose the upper surface of the barrier layer. In the subsequent second polishing step, the chemical mechanical polishing removes the remaining part of the portion of the conductive layer positioned outside the trench and the portion of the barrier layer positioned outside the trench in order to expose the upper surface of the insulating layer.

Patent Document 1 discloses a polishing composition of first conventional technology comprising an abrasive material such as silicon dioxide, α-alanine, hydrogen peroxide, and water. Patent Document 2 discloses a polishing composition of second conventional technology comprising an abrasive material such as alumina, an oxidizing agent such as peracetic acid, a complexing agent such as citric acid, and a film-forming agent such as imidazole. The abrasive material has an effect for mechanically polishing an object to be polished, and α-alanine and the complexing agent have an effect for improving the polishing of an object made of a copper-containing metal to be polished. The polishing compositions of first and second conventional technologies are used for the chemical mechanical polishing in the first polishing step.

Patent Document 3 discloses a polishing composition of third conventional technology comprising an abrasive material, an oxidizing agent, a reducing agent and water. The oxidizing agent and the reducing agent have an effect for improving the polishing of the barrier layer. Patent Document 4 discloses a polishing composition of fourth conventional technologies comprising a triazole derivative which has an effect for inhibiting erosion of the conductive layer. Patent Document 5 discloses a polishing composition of the fifth conventional technology containing an abrasive material comprising silica having a primary particle size of 20 nm or less. The silica having a primary particle size of 20 nm or less has a high ability for polishing the conductive layer and the barrier layer. The polishing compositions of the third to fifth conventional technologies are used for the chemical mechanical polishing in the second polishing step.

When the polishing compositions of the first and second conventional technologies are used for the chemical mechanical polishing in the first polishing step, a phenomenon called dishing occurs in which the level of the upper surface of the conductive layer is lowered. When the polishing compositions of the third to fifth conventional technologies are used for the chemical mechanical polishing in the second polishing step, not only dishing but also so-called erosion occurs, a phenomenon in which the level of the upper surface of the region where the trenches are densely formed is lowered. Occurrence of dishing and erosion produces a difference in level on the surface of the polished device, thereby remarkably reducing the flatness of the surface of the polished device, resulting in difficult formation of multi-layered wiring. Dishing and erosion also causes narrow sectional areas for wiring, resulting in increased wiring resistance.
Patent Document 1:
   Japanese Laid-open Patent Publication No. 2000-160141
Patent Document 2:
   Japanese Laid-open Patent Publication No. 11-21546
Patent Document 3:
   Japanese Laid-open Patent Publication No. 2000-160139
Patent Document 4:
   Japanese Laid-open Patent Publication No. 2001-89747
Patent Document 5:
   Japanese Laid-open Patent Publication No. 2001-247853

### DISCLOSURE OF THE INVENTION

An object of the present invention is to provide a polishing composition which hardly causes dishing and erosion when used in polishing for forming wiring in semiconductor devices, and to provide a polishing method which hardly causes dishing and erosion.

In order to achieve the aforementioned object, the present invention provides a polishing composition. The polishing composition is a polishing composition for use in polishing for forming the wiring in a semiconductor device and contains colloidal silica, an acid, an anticorrosive, a complete saponified polyvinyl alcohol, and water.

In another aspect of the present invention, a polishing method is provided. In the polishing method, an object is polished in order to form wiring in a semiconductor device using the aforementioned polishing composition.

The present invention also provides another polishing method. In the polishing method, an object is polished in order to form wiring in a semiconductor device. The object has a barrier layer and a conductive layer in this order on an insulating layer having a trench. The barrier layer and the conductive layer have a portion positioned outside the trench and a portion positioned inside the trench, respectively. The polishing method includes removing the portion of the conductive layer positioned outside the trench and the portion of the barrier layer positioned outside the trench by chemical mechanical polishing using the aforementioned polishing composition to expose the upper surface of the insulating layer.

The present invention further provides another polishing method. The polishing method includes removing a part of the portion of the conductive layer positioned outside the trench by chemical mechanical polishing to expose the upper surface of the barrier layer, and removing the remaining part of the portion of the conductive layer positioned outside the trench and the portion of the barrier layer positioned outside the trench by chemical mechanical polishing to expose the upper surface of the insulating layer. A first polishing composition is used in the chemical mechanical polishing to remove the portion of the conductive layer positioned outside the trench. A second polishing composition is used in the chemical mechanical polishing to remove the remaining part of the portion of the conductive layer positioned outside the trench and the portion of the barrier layer positioned outside the trench. The first polishing composition contains a surfactant, a silicon oxide, a carboxylic acid, an anticorrosive, an oxidizing agent and water. The second polishing composition contains colloidal silica, an acid, an anticorrosive, a complete saponified polyvinyl alcohol, and water. The surfactant includes at least one selected from the compounds represented by general formulae (1) to (7) and salts thereof.

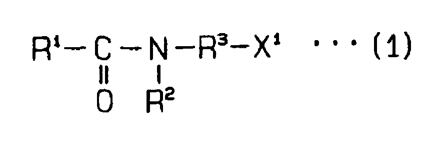

In the general formula (1), R¹ represents an alkyl group having 8 to 16 carbon atoms. R² represents a hydrogen atom, a methyl group, or an ethyl group. R³ represents an alkylene group having 1 to 8 carbon atoms, -(CH₂CH₂O)ₗ-, -(CH₂CH(CH₃)O)ₘ-, or a combination of at least two thereof. When R³ represents -(CH₂CH₂O)ₗ- or -(CH₂CH(CH₃)O)ₘ-, 1 and m are an integer of 1 to 8. When R³ represents the combination of -(CH₂CH₂O)ₗ- and - (CH₂CH(CH₃)O)ₘ-, the sum of 1 and m is an integer of 8 or less. X¹ represents a carboxy group or a sulfone group.

R⁴-Z-Y-X² (2)

R⁴-Z-X² (3)

In the general formulae (2) and (3), R⁴ represents an alkyl group having 8 to 16 carbon atoms. Z is a functional group represented by the chemical formula (i) or (ii). Y¹ represents -(CH₂CH₂O)ₙ-, -(CH₂CH(CH₃)O)ₚ-, or a combination of - (CH₂CH₂O)ₙ,- and -(CH₂CH(CH₃)O)ₚ-. When Y¹ represents (CH₂CH₂O)ₙ,- or -(CH₂CH(CH₃)O)ₚ-, n and p are an integer of 1 to 6. When Y¹ represents the combination of -(CH₂CH₂O)ₙ- and - (CH₂CH(CH₃)O)ₚ-, the sum of n and p is an integer of 6 or less. X² represents a phosphoric acid group or sulfone group.

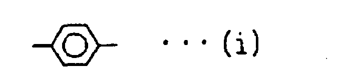

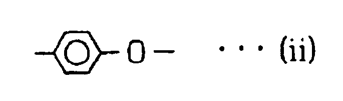

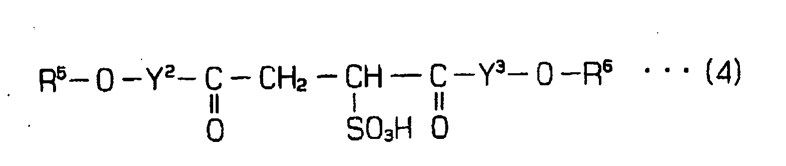

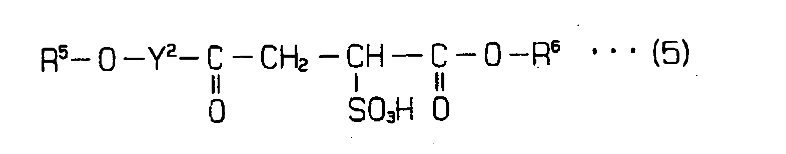

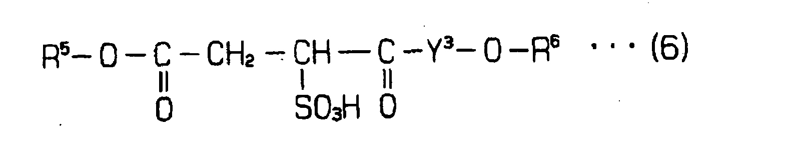

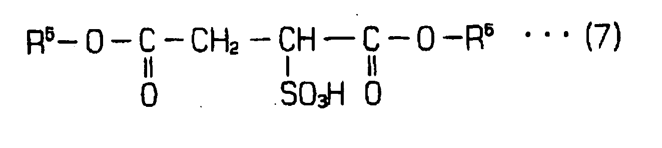

In the general formulae (4) to (7), each of R⁵ and R⁶ represents a hydrogen atom, a hydroxy group, or an alkyl group having 8 to 16 carbon atoms. Each of Y² and Y³ represents - (CH₂CH₂O)_{q}-, -(CH₂CH(CH₃)O)ᵣ-, or a combination of -(CH₂CH₂O)_{q}- and -(CH₂CH(CH₃)O)ᵣ-. When Y² or Y³ represents -(CH₂CH₂O)_{q}- or - (CH₂CH(CH₃)O)ᵣ-, q and r are an integer of 1 to 6. When Y² or Y³ represents the combination of -(CH₂CH₂O)_{q}- and - (CH₂CH(CH₃)O)ᵣ-, the sum of q and r is an integer of 6 or less.

The present invention provides still another polishing method. In the polishing method, the first polishing composition used in the chemical mechanical polishing to remove a part of the portion of the conductive layer positioned outside the trench contains an α-amino acid, a benzotriazole derivative, a silicon oxide, a surfactant, an oxidizing agent and water. The second polishing composition used in the chemical mechanical polishing to remove the remaining part of the portion of the conductive layer positioned outside the trench and the portion of the barrier layer positioned outside the trench contains colloidal silica, an acid, an anticorrosive, a complete saponified polyvinyl alcohol, and water. The benzotriazole derivative is represented by the general formula (8):

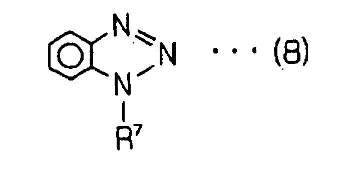

In the general formula (8), R⁷ represents an alkyl group having a carboxy group, an alkyl group having a hydroxyl group and a tertiary amino group, an alkyl group having a hydroxy group, or an alkyl group other than those.

### BRIEF DESCRIPTION OF THE DRAWINGS

Figs. 1(a) to 1(d) are schematic sectional views for explaining the polishing method according to a first embodiment of the invention;
Fig. 2(a) is a schematic sectional view of dishing at the end of the first polishing step;
Fig. 2(b) is a schematic sectional view of erosion at the end of the first polishing step;
Fig. 3(a) is a schematic sectional view of dishing at the end of the second polishing step; and
Fig. 3(b) is a schematic sectional view of erosion at the end of the second polishing step.

### BEST MODE FOR CARRYING OUT THE INVENTION

In the following, a first embodiment of the present invention is explained.

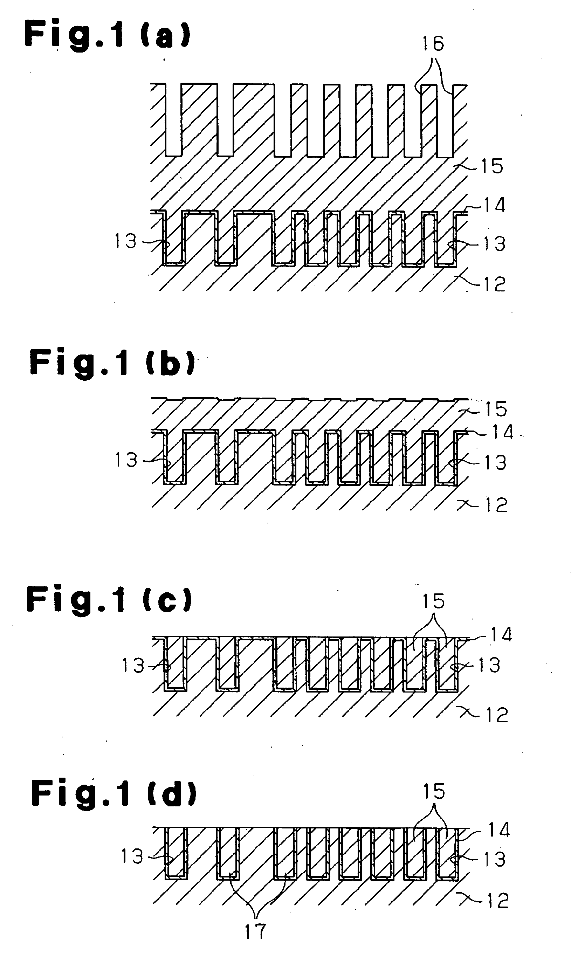

Firstly, a method for forming the wiring in a semiconductor device is explained. When forming the wiring in a semiconductor device, first, as shown in Fig. 1 (a), a barrier layer 14 and a conductive layer 15 are formed on an insulating layer 12 having a trench 13.

The insulating layer 12 may be a SiO2 film, a SiOF film or a SiOC film. The insulating layer 12 is formed, for example, by a chemical vapor deposition (CVD) method by using tetraethoxysilane (TEOS). The trench 13 is formed, for example, by a known lithography technique and a pattern etching technique so as to have a predetermined design pattern.

The barrier layer 14 is provided on the insulating layer 12 so as to cover the surface of the insulating layer 12, prior to the formation of the conductive layer 15. The barrier layer 14 is formed, for example, by a sputtering method. Desirably, the barrier layer 14 has a sufficiently small thickness in comparison with the depth of the trench 13. The barrier layer 14 is made, for example, of tantalum or a tantalum-containing compound such as tantalum nitride.

The conductive layer 15 is provided on the barrier layer 14 so as to bury at least the trench 13. The conductive layer 15 is formed, for example, by a physical vapor deposition (PVD). The conductive layer 15 is made, for example, of a copper-containing metal. The copper-containing metal may be copper, or may be a copper-aluminum alloy or a copper-titanium alloy. The conductive layer 15 formed on the insulating layer 12 having the trench 13 generally has an upper surface with an initial recess 16 which corresponds to the trench 13.

Subsequently, the portion of the conductive layer 15 and the portion of the barrier layer 14 which are both positioned outside the trench 13 are removed by the chemical mechanical polishing. This chemical mechanical polishing is carried out by two divided steps of a first polishing step and a second polishing step. Firstly, in the first polishing step, as shown in Fig. 1(c), in order to expose the upper surface of the barrier layer 14 , a part of the portion of the conductive layer 15 positioned outside the trench 13 is removed by the chemical mechanical polishing. In the subsequent second polishing step, as shown in Fig. 1(d), in order to expose the upper surface of the insulating layer 12, the remaining part of the portion of the conductive layer 15 positioned outside the trench 13 and the portion of the barrier layer 14 positioned outside the trench 13 are removed by the chemical mechanical polishing. As a result, a portion of the conductive layer 15 positioned inside the trench 13 remains on the insulating layer 12, and the portion functions as the wiring 17 of a semiconductor device. The barrier layer 14 plays a role in preventing the copper in the conductive layer 15 (wiring 17) from diffusing into the insulating layer 12.

In the chemical mechanical polishing of the first polishing step, the first polishing composition is employed in order to inhibit occurrence of dishing and erosion during the first polishing step. In the chemical mechanical polishing of the second polishing step, the second polishing composition is employed in order to inhibit occurrence of dishing and erosion during the second polishing step.

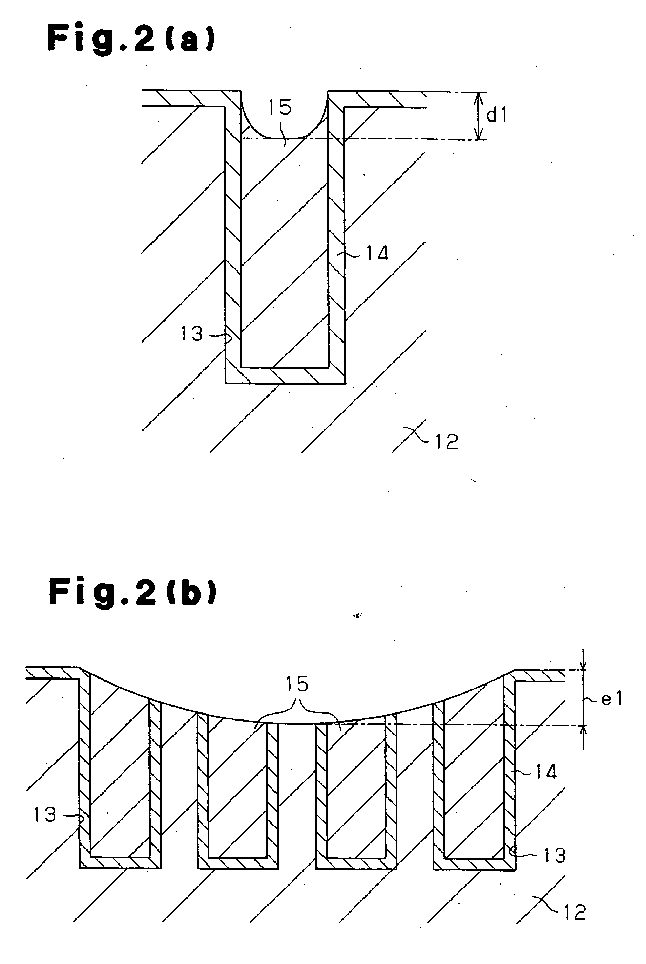

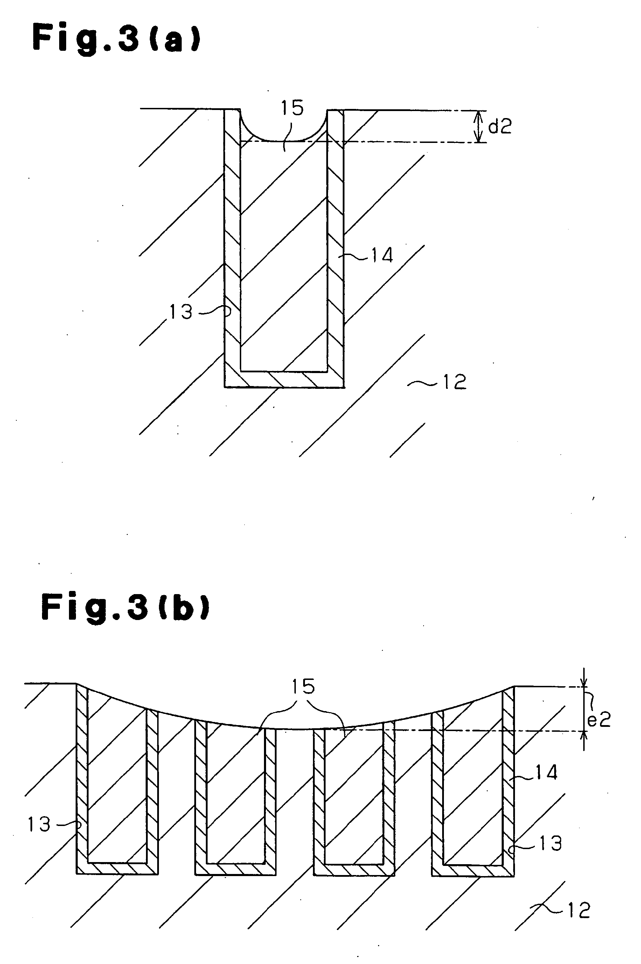

The degree of occurrence of dishing and erosion is indicated by the depth of dishing and the depth of erosion as an index, respectively. The depth of dishing at the end of the first polishing step is, as shown in Fig. 2(a), the difference d1 in the level between the upper surface of the conductive layer 15 which remains on the insulating layer 12 and the upper surface of the portion of the barrier layer 14 positioned outside the trench 13. The depth of dishing at the end of the second polishing step is, as shown in Fig. 3(a), the difference d2 in the level between the upper surface of the conductive layer 15 which remains on the insulating layer 12 and the upper surface of the insulating layer 12. The depth of erosion at the end of the first polishing step is, as shown in Fig. 2(b), the difference e1 in the level between the upper surface of the wiring region where the trenches 13 are densely formed and the upper surface of the portion of the barrier layer 14 positioned outside the trench 13 in the region other than the wiring region. The depth of erosion at the end of the second polishing step is, as shown in Fig. 3(b), the difference e2 in the level between the upper surface of the wiring region and the upper surface of the insulating layer 12 in the region other than the wiring region.

The first polishing composition used in the chemical mechanical polishing of the first polishing step comprises a component (a) comprising a surfactant, a component (b) comprising a silicon oxide, a component (c) comprising a carboxylic acid, a component (d) comprising an anticorrosive, a component (e) comprising an oxidizing agent, and a component (f) comprising water.

The component (a), that is, the surfactant comprises at least one selected from the compounds represented by the general formulae (9) to (15) and salts thereof. The surfactant preferably comprises at least one selected from the first group consisting of the compounds represented by the general formulae (9) to (15) and salts thereof, and at least one selected from the second group consisting of the compounds represented by the general formula (16) or (17) and salts thereof.

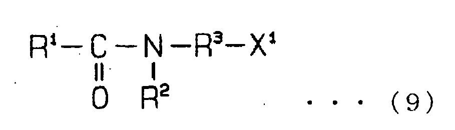

R⁴-Z-Y¹-X² (10)

R⁴-Z-X² (11)

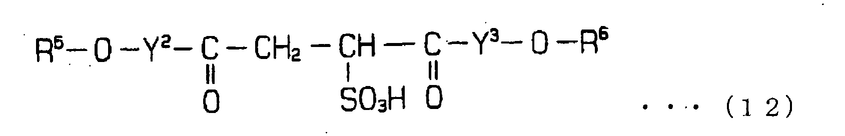

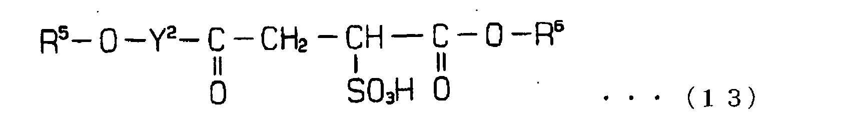

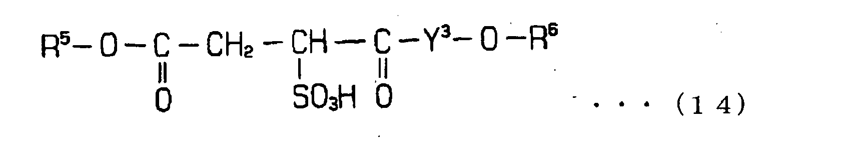

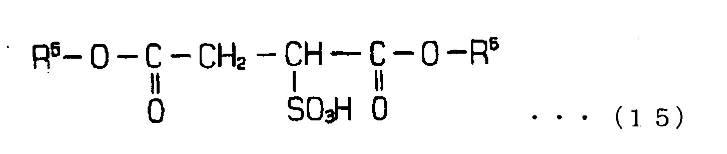

R⁷-O-Y⁴-SO₃H (16)

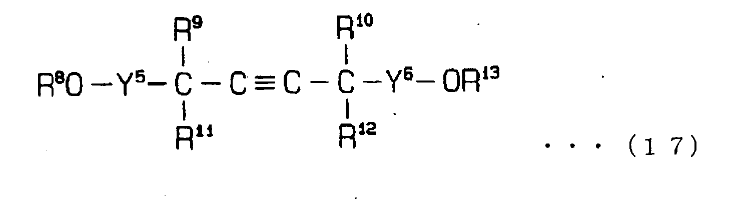

In the general formula (9), R¹ represents an alkyl group having 8 to 16 carbon atoms. R² represents a hydrogen atom, a methyl group, or an ethyl group. R³ represents an alkylene group having 1 to 8 carbon atoms, - (CH₂CH₂O)ₗ-, -(CH₂CH(CH₃)O)ₘ-, or a combination of at least two thereof, provided that, when R³ represents -(CH₂CH₂O)ₗ- or -(CH₂CH(CH₃)O)ₘ-, 1 and m are an integer of 1 to 8, and when R³ represents the combination of - (CH₂CH₂O)₁- and -(CH₂CH(CH₃)O)ₘ-, that is a residue produced by removing a hydrogen atom from a copolymer of ethylene oxide and propylene oxide, the sum of 1 and m is an integer of 8 or less. X¹ represents a carboxy group or a sulfone group.

In the general formulae (10) and (11), R⁴ represents an alkyl group having 8 to 16 carbon atoms. Z is a functional group represented by the chemical formula (i) or (ii). Y¹ represents -(CH₂CH₂O)ₙ-, -(CH₂CH(CH₃)O)ₚ-, or a combination of - (CH₂CH₂O)ₙ- and -(CH₂CH(CH₃)O)ₚ-, provided that, when Y¹ represents -(CH₂CH₂O)ₙ- or -(CH₂CH(CH₃)O)ₚ-, n and p are an integer of 1 to 6, and when Y¹ represents the combination of - (CH₂CH₂O)ₙ- and -(CH₂CH(CH₃)O)ₚ-, that is a residue produced by removing a hydrogen atom from a copolymer of ethylene oxide and propylene oxide, the sum of n and p is an integer of 6 or less. X² represents phosphoric acid group or a sulfone group.

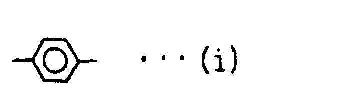

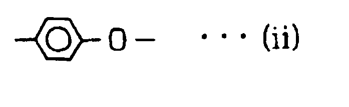

In the general formulae (12) to (15), each of R⁵ and R⁶ represents a hydrogen atom, a hydroxyl group, or an alkyl group having 8 to 16 carbon atoms. Each of Y² and Y³ represents -(CH₂CH₂O)_{q}-, -(CH₂CH(CH₃)O)ᵣ-, or a combination of - (CH₂CH₂O)_{q}- and -(CH₂CH(CH₃)O)ᵣ-, provided that, when Y² or Y³ represents -(CH₂CH₂O)_{q}- or -(CH₂CH(CH₃)O)ᵣ-, q and r are an integer of 1 to 6, and when Y² or Y³ represents the combination of -(CH₂CH₂O)_{q}- and -(CH₂CH(CH₃)O)ᵣ-, the sum of q and r is an integer of 6 or less.

In the general formula (16), R⁷ represents an alkyl group having 8 to 16 carbon atoms. Y⁴ represents -(CH₂CH₂O)ₛ-, -(CH₂CH(CH₃)O)ₜ-, or a combination of -(CH₂CH₂O)ₛ- and - (CH₂CH(CH₃)O)ₜ-, provided that, when Y⁴ represents -(CH₂CH₂O)ₛ- or -(CH₂CH(CH₃)O)ₜ-, s and t are an integer of 2 to 30, and when Y⁴ represents the combination of -(CH₂CH₂O)ₛ- and - (CH₂CH(CH₃)O)ₜ-, the sum of s and t is an integer of 30 or less.

In the general formula (17), R⁸ to R¹³ represent a hydrogen atom, or an alkyl group having 1 to 10 carbon atoms, respectively. Y⁵ and Y⁶ represent -(CH₂CH₂O)ᵤ-, -(CH₂CH(CH₃)O)ᵥ-, respectively, provided that, u and v are an integer of 1 to 20.

The salts of the compounds represented by the general formulae (9) to (17) include, for example, an ammonium salt, an alkaline metal salt such as sodium salt and triethanolamine salt. The compounds represented by the general formulae (9) to (16) and salts thereof are an anionic surfactant, and the compound represented by the general formula (17) and a salt thereof are a nonionic surfactant.

Specific examples of the compound represented by the general formula (9) and a salt thereof include coconut oil fatty acid sarcosine triethanolamine represented by the chemical formula (18), coconut oil fatty acid methyl taurin sodium represented by the chemical formula (19), and sodium polyoxyethylene coconut oil fatty acid monoethanolamide sulfate represented by the chemical formula (20).

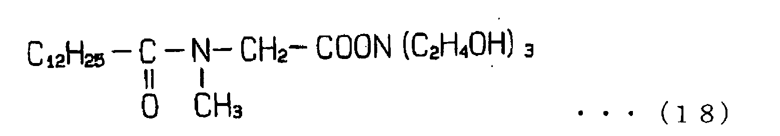

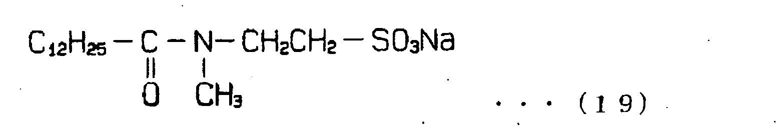

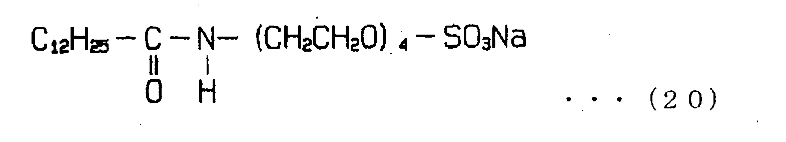

Specific examples of the compound represented by the general formula (10) or (11) and a salt thereof include polyoxyethylene alkylphenyl ether phosphate represented by the chemical formula (21), and dodecylbenzene sulfonic acid triethanolamine represented by the chemical formula (22).

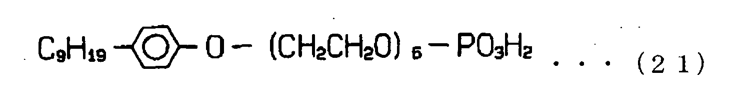

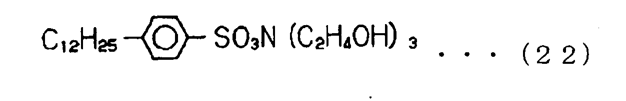

Specific examples of the compounds represented by the general formulae (12) to (15) and salts thereof include disodium polyoxyethylene alkyl sulfosuccinate represented by the chemical formula (23) and a dioctyl series sulfosuccinate represented by the chemical formula (24).

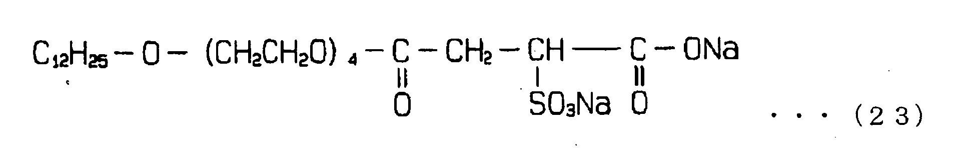

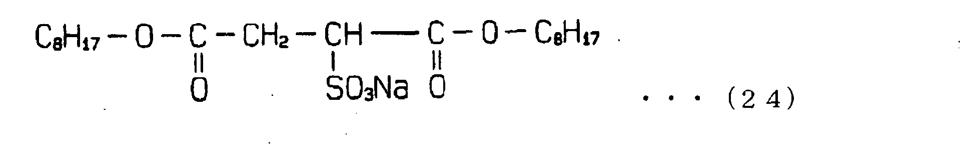

Specific examples of the compound represented by the general formula (16) and a salt thereof include polyoxyethylene lauryl ether sulfate triethanolamine represented by the chemical formula (25).

C₁₂H₂₅-O-(CH₂CH₂O)₂-SO₃N(C₂H₄OH)₃ (25)

Specific examples of the compound represented by the general formula (17) and a salt thereof include diisobutyldimethylbutynediol polyoxyethylene glycol ether represented by the chemical formula (26).

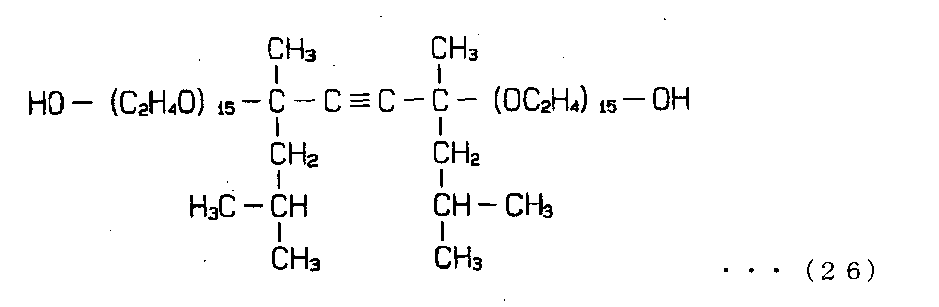

The compound of the first group and second group, that is, the compounds represented by the formulae (8) to (17) and salts thereof have an effect for reducing a depth of dishing to inhibit the occurrence of dishing. The compound of the first group has a strong effect for inhibiting the occurrence of dishing to some extent in comparison with the compound of the second group. The compound of the first group, however, has a remarkably strong effect for inhibiting the polishing of a copper-containing metal in comparison with the compound of the second group. Therefore, a surfactant, which comprises at least one selected from the first group and at least one selected from the second group, is unlikely to inhibit excessively the polishing of the copper-containing metal in comparison with a surfactant comprising at least one selected from the first group alone.

The first polishing composition has preferably a surfactant content of 0.025 to 0.2% by mass, more preferably 0.03 to 0.1% by mass. If the surfactant content is less than 0.025% by mass, the depth of dishing is not so decreased, and thus there is a possibility that occurrence of dishing will not be inhibited. If the surfactant content is more than 0.2% by mass, the polishing of the copper-containing metal is strongly inhibited, and thus there is a possibility that some of the conductive layer 15 to be removed will remain on the insulating layer 12 after polishing.

When the surfactant comprises at least one selected from the first group and at least one selected from the second group, the ratio of mass of the compound of the first group relative to the mass of the compound of the second group in the surfactant is preferably 1/1 to 10/1. If the ratio is less than 1/1, there is a possibility that the occurrence of dishing will not be so inhibited. If the ratio is more than 10/1, the polishing of the copper-containing metal is strongly inhibited, and thus there is a possibility that some of the conductive layer 15 to be removed will remain on the insulating layer 12 after polishing.

The component (b), that is, silicon oxide has an effect for mechanically polishing the object to be polished. The silicon oxide may be, for example, colloidal silica, fumed silica, or precipitated silica. Among them, because of high ability for polishing the copper-containing metal, the colloidal silica or the fumed silica is preferable, and the colloidal silica is more preferable. The first polishing composition may contain two or more silicon oxides.

The silicon oxide has preferably an average particle size D_{N4} of 0.01 to 0.5 µm measured by a laser diffraction scanning method, and more preferably 0.03 to 0.3 µm. A silicon oxide having an average particle size D_{N4} of less than 0.01 µm has a weak effect for mechanically polishing the object to be polished, and thus some of the conductive layer 15 to be removed will remain on the insulating layer 12 after the polishing. A silicon oxide having an average particle size D_{N4} of more than 0.5 µm provides a first polishing composition with too high ability for polishing not only the copper-containing metal of the conductive layer 15 but also the barrier layer 14 and the insulating layer 12, thereby being likely to increase the depth of erosion. Silicon oxide having an average particle size D_{N4} of more than 0.5 µm easily precipitates, thereby being likely to lower the dispersion stability of the first polishing composition.

The content of silicon oxide in the first polishing composition is preferably 0.01 to 10% by mass, and more preferably 0.1 to 3% by mass. If the content of silicon oxide is less than 0.01% by mass, because of insufficient ability of the first polishing composition, which polishes the object to be polished, there is a possibility that some of the conductive layer 15 to be removed will remain on the insulating layer 12 after the polishing. If the content of silicon oxide is more than 10% by mass, because of high ability of the first polishing composition, which polishes the object to be polished, there is a possibility that the depth of dishing and the depth of erosion will be increased.

The component (c), that is, the carboxylic acid has an action for chelate bonding with copper, and thus it contributes to improvement in the ability of the first polishing composition for polishing the conductive layer 15. In view of particular improvement of the first polishing composition to polish the conductive layer 15, the carboxylic acid has preferably a carbon atom number of 10 or less in the molecule. The carboxylic acid may be any of a monocarboxylic acid or a dicarboxylic acid, and may contain an amino group or a hydroxyl group. Specific examples of the carboxylic acid include an α-amino acid such as glycine, alanine or valine, citric acid, oxalic acid, succinic acid, maleic acid, and tartaric acid. Among them, the α-amino acid is preferable because of an effect for reducing the depth of dishing, and alanine is more preferable.

The content of carboxylic acid in the first polishing composition is preferably 0.01 to 2% by mass, and more preferably 0.4 to 1.5% by mass. If the content of carboxylic acid is less than 0.01% by mass, because of insufficient ability of the first polishing composition for polishing the copper-containing metal, there is a possibility that some of the conductive layer 15 to be removed will remain on the insulating layer 12 after the polishing. If the content of carboxylic acid is more than 2% by mass, because of too high concentration of the carboxylic acid, there is a possibility that the ability of the first polishing composition for polishing the conductive layer 15 will be lowered and a possibility that the depth of dishing will be increased.

The component (d), that is, the anticorrosive has an effect for preventing the copper-containing metal from corrosion caused by an oxidizing agent, thereby preventing the surface of the conductive layer 15 from corrosion. In addition, the anticorrosive has an effect for inhibiting excess polishing of the conductive layer 15, thereby inhibiting the occurrence of dishing. Specific examples of the anticorrosive are, for example, benzotriazoles (benzotriazole and a derivative thereof). The benzotriazole and a derivative thereof are represented by the general formula (27). The carbon atoms at the 4-position, 5-position, 6-position and 7-porition of the benzotriazole and derivative thereof may be substituted by a nitrogen atom, respectively, and the nitrogen atom at the 1-position may be substituted by a carbon atom.

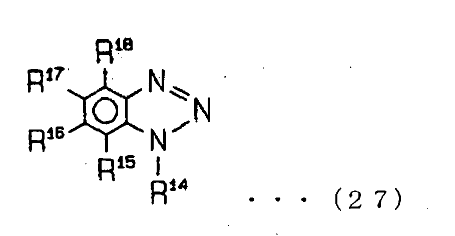

In the general formula (27), R¹⁴ represents a hydrogen atom, an alkyl group having a carboxy group, an alkyl group having a hydroxy group and a tertiary amino group, an alkyl group having a hydroxyl group, or an alkyl group other than those. R¹⁵ to R¹⁸ represent a hydrogen atom or an alkyl group, respectively.

Among the compounds represented by the general formula (27), the benzotriazole derivative represented by the general formula (28) is preferable because of a strong effect for protecting the surface of the conductive layer 15. In the general formula (28), R¹⁴ represents an alkyl group having a carboxy group, an alkyl group having a hydroxy group and a tertiary amino group, an alkyl group having a hydroxy group, or an alkyl group other than those.

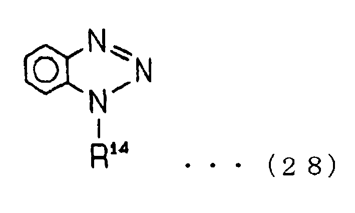

The benzotriazole derivative represented by the general formula (28) in which R¹⁴ is an alkyl having a carboxyl group includes a compound represented by the general formula (29). Specific examples of the compound represented by the general formula (29) include 1-(1,2-dicarboxyethyl)benzotriazole represented by the chemical formula (30).

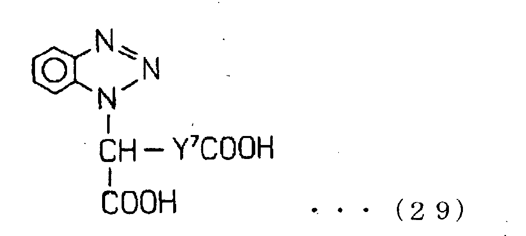

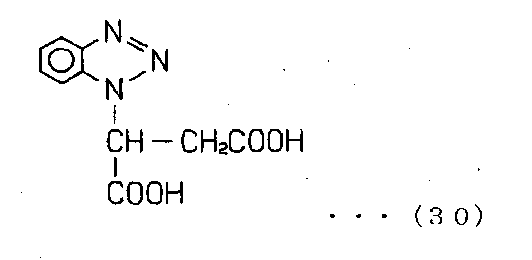

The benzotriazole derivative represented by the general formula (28) in which R¹⁴ is an alkyl having a hydroxy group and a tertiary amino group includes a compound represented by the general formula (31). Specific examples of the compound represented by the general formula (31) include 1-[N,N-bis(hydroxyethyl)aminomethyl]benzotriazole represented by the chemical formula (32).

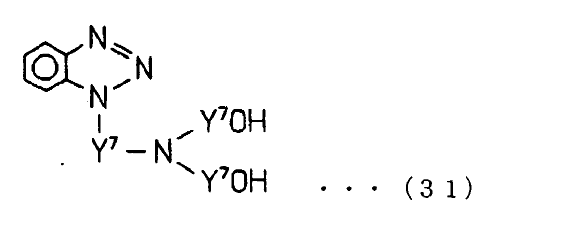

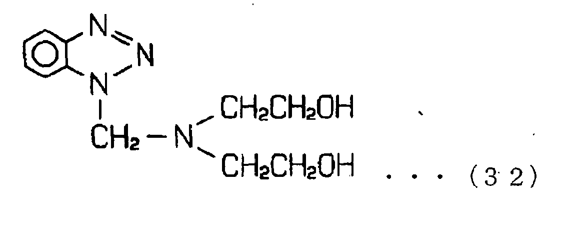

The benzotriazole derivative represented by the general formula (28) in which R¹⁴ is an alkyl having a hydroxy group includes a compound represented by the general formula (33) and a compound represented by the general formula (34). Specific examples of the compound represented by the general formula (33) and the compound represented by the general formula (34) include 1-(2,3-dihydroxypropyl)benzotriazole represented by the chemical formula (35) and 1-(hydroxymethyl)benzotriazole represented by the chemical formula (36).

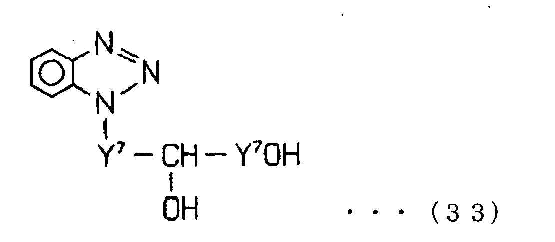

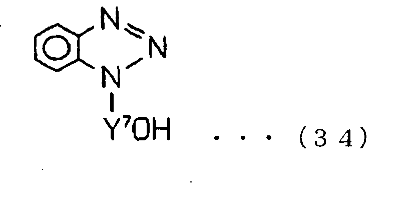

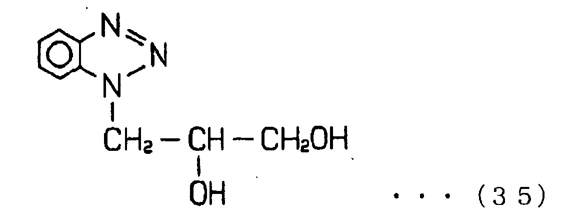

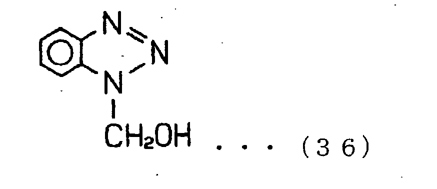

In the general formulae (29), (31), (33) and (34), Y⁷ represents an alkylene group.

The first polishing composition may contain two or more kinds of the anticorrosives. Among the aforementioned anticorrosives, 1-[N,N-bis(hydroxyethyl)aminomethyl]benzotriazole represented by the chemical formula (32) is most preferable because of the particularly strong effect for protecting the surface of the conductive layer 15.

The content of the anticorrosive in the first polishing composition is preferably 0.1% by mass or less. When the anticorrosive is benzotriazole, the content of the anticorrosive in the first polishing composition is preferably 0.000001 to 0.001% by mass, and more preferably 0.00003 to 0.0005% by mass. When the anticorrosive is 1-[N,N-bis(hydroxyethyl)aminomethyl]benzotriazole, the content of the anticorrosive in the first polishing composition is preferably 0.00005 to 0.005% by mass, and more preferably 0.0001 to 0.001% by mass. When the anticorrosive is 1-(2,3-dihydroxypropyl)benzotriazole, the first polishing composition has preferably an anticorrosive content of the anticorrosive in the first polishing composition is preferably 0.001 to 0.1% by mass, and more preferably 0.003 to 0.05% by mass. When the anticorrosive is 1-(1,2-dicarboxyethyl)benzotriazole, the content of the anticorrosive in the first polishing composition is preferably 0.0005 to 0.01% by mass, and more preferably 0.002 to 0.08% by mass.

If the content of the anticorrosive is too small, because of insufficient action for protecting the surface of the conductive layer 15 and for inhibiting occurrence of dishing, there is a possibility of roughening of the surface of the conductive layer 15 after the polishing is brought about and increasing the depth of dishing. If the content of the anticorrosive is too large, because of insufficient ability of the first polishing composition for polishing the copper-containing metal, there is a possibility that some of the conductive layer 15 to be removed will remain on the insulation layer 12 after polishing.

The component (e), that is, the oxidizing agent has an effect for oxidizing the copper-containing metal, thereby accelerating the ability of silicon oxide for mechanically polishing the conductive layer 15. The oxidizing agent may be a persulfate such as ammonium persulfate, potassium persulfate or sodium persulfate, or may be periodic acid, peracetic acid, perchloric acid, ammonium percarbonate, or hydrogen peroxide. Among them, the persulfate is preferable because of high ability for oxidizing copper, and ammonium persulfate is more preferable.

The content of the oxidizing agent in the first polishing composition is preferably 0.5 to 10% by mass, and more preferably 1 to 5% by mass. If the content is less than 0.5% by mass, because of insufficient ability of the first polishing composition for polishing the copper-containing metal, there is a possibility that some of the conductive layer 15 to be removed will remain on the insulating layer 12 after polishing. If the content of the oxidizing agent is more than 10% by mass, because of too high ability of the first polishing composition for polishing the copper-containing metal, there is a possibility that the depth of dishing will be increased.

The component (f), that is, water has a role as a medium for dissolving or dispersing the components other than water in the first polishing composition. Preferably, the water as much as possible does not contain any impurities. Specific examples include pure water, ultrapure water prepared by removing impurity ions with an ion exchange resin followed by removing foreign substances through a filter, and distilled water.

The first polishing composition preferably has a pH of 7 or more, more preferably 7 to 12, and most preferably 8 to 10. A first polishing composition having a pH of less than 7 is likely to have a lowered ability for polishing the copper-containing metal. A first polishing composition having a pH of more than 12 has too high ability for polishing the copper-containing metal, thereby being likely to increase the depth of dishing. The pH of the first polishing composition may be adjusted by addition with ammonia.

The first polishing composition is prepared by adding the components (a) to (e) to water, followed by mixing. For mixing, a blade-type agitator, ultrasonic dispersing apparatus, or the like may be employed. The order of addition of the components (a) to (e) to water is not limited.

The first polishing composition may further contain, as necessary, a thickener, an antifoaming agent, a preservative, and the like.

When carrying out the chemical polishing in the first polishing step using the first polishing composition, a polishing pad is pressed to the surface of the conductive layer 15 and rotated while supplying the polishing composition to the surface of the conductive layer 15.

The second polishing composition used in the chemical mechanical polishing of the second polishing step comprises a component (g) comprised of colloidal silica, a component (h) comprised of an acid, a component (i) comprised of an anticorrosive, a component (j) comprised of a completely saponified polyvinyl alcohol, and a component (k) comprised of water.

The component (g), that is, the colloidal silica has an effect for mechanically polishing the object to be polished. Colloidal silica synthesized by a sol-gel method, which contains extremely small trace amounts of atomic impurities, is preferably added to the second polishing composition. The synthesis of the colloidal silica by the sol-gel method is carried out by dropwise adding methyl silicate into a solvent comprising methanol, ammonia and water to effect hydrolysis. Colloidal silica synthesized by an ion exchange method may be used if contamination by atomic impurities is not taken into consideration. For synthesizing the colloidal silica by the ion exchange method, sodium silicate is used as a starting material.

The colloidal silica has preferably an average particle size D_{N4} of 0.01 to 0.5 µm measured by a laser diffraction scattering method, and more preferably 0.03 to 0.3 µm. If the colloidal silica has an average particle size D_{N4} of less than 0.01 µm, there is a possibility that the second polishing composition will have insufficient ability to polish the object to be polished. If the colloidal silica has an average particle size D_{N4} of more than 0.5 µm, there is a possibility that the depth of erosion will be increased.

The colloidal silica is preferably a mixture of a first colloidal silica and a second colloidal silica which has a smaller average particle size than the first colloidal silica. The first colloidal silica has preferably an average particle size of 0.05 µm or more and 0.3 µm or less, and more preferably 0.05 µm or more and 0.1 µm or less. If the first colloidal silica has an average particle size of less than 0.05 µm, there is a possibility that the second polishing composition will have insufficient ability to polish the insulating layer 13. If the first colloidal silica has an average particle size of more than 0.3 µm, there is a possibility that the second polishing composition will have too high ability for polishing the insulating layer 13, thereby increasing the depth of erosion. The second colloidal silica has preferably an average particle size of 0.01 µm or more and less than 0.05 µm, and more preferably 0.02 µm or more and 0.04 µm or less. If the second colloidal silica has an average particle size of less than 0.01 µm and more than 0.05 µm, there is a possibility that the second polishing composition will have insufficient ability to polish the barrier layer 14.

The content of the colloidal silica in the second polishing composition is preferably 0.01 to 20% by mass, and more preferably 0.1 to 10% by mass. If the content of the colloidal silica in the second polishing composition is less than 0.01% by mass, there is a possibility that the second polishing composition will have insufficient ability to polish the barrier layer 14. If the content of the colloidal silica in the second polishing composition is more than 20% by mass, there is a possibility that the occurrence of a difference in the level of the surface will not be sufficiently inhibited.

The component (h), that is, the acid contributes to improving the ability of the second polishing composition for polishing the barrier layer 14. In view of particular improvement in the ability of the second polishing composition for polishing the barrier layer 14, the acid to be contained in the second polishing composition is preferably at least one selected from nitric acid, hydrochloric acid, sulfuric acid, lactic acid, acetic acid, oxalic acid, citric acid, malic acid, succinic acid, butyric acid and malonic acid, more preferably at least one selected from nitric acid, oxalic acid, and lactic acid, and most preferably nitric acid. The second polishing composition, which contains nitric acid as the acid, is improved in storage stability, and is inhibited from the lowering of the polishing ability with lapse of time.

The content of an acid in the second polishing composition is preferably 0.01 to 3% by mass, more preferably 0.01 to 0.3% by mass, and most preferably 0.03 to 0.1% by mass. If the content of the acid in the second polishing composition is less than 0.01% by mass, there is a possibility that the second polishing composition will have insufficient ability to polish the barrier layer 14. If the content of the acid in the second polishing composition is more, since the composition has very low pH, there is a possibility that handling ability of the second polishing composition will be lowered. If the content of the acid in the second polishing composition is 0.03 to 0.1% by mass, the occurrence of a difference in the level on the surface will be strongly inhibited.

The component (i), that is, the anticorrosive has an effect for protecting the surface of the conductive layer 15 from corrosion caused by the acid. In addition, the anticorrosive has an effect for inhibiting excess polishing of the conductive layer 15, thereby inhibiting also the occurrence of dishing. Specific examples of the anticorrosive include, for example, benzotriazole and a derivative thereof. The benzotriazole and derivative thereof are represented by the general formula (37). The carbon atoms at the 4-position, 5-position, 6-position and 7-porition of the benzotriazole and derivative thereof may be substituted by a nitrogen atom, respectively, and the nitrogen atom at the 1-position may be substituted by a carbon atom.

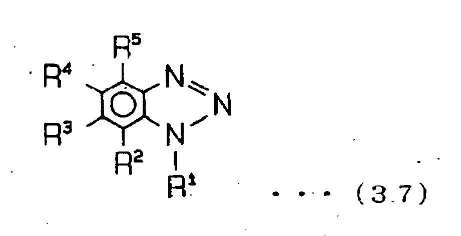

In the general formula (37), R¹ represents a hydrogen atom, an alkyl group having a carboxy group, an alkyl group having a hydroxy group and a tertiary amino group, an alkyl group having a hydroxy group, or an alkyl group other than those. R² to R⁵ represent a hydrogen atom or an alkyl group, respectively.

Among the compounds represented by the general formula (37), the benzotriazole derivative represented by the general formula (38) is preferable because of a strong effect for protecting the surface of the conductive layer 15. In the general formula (38), R¹ represents an alkyl group having a carboxy group, an alkyl group having a hydroxy group and a tertiary amino group, an alkyl group having a hydroxy group, or an alkyl group other than those.

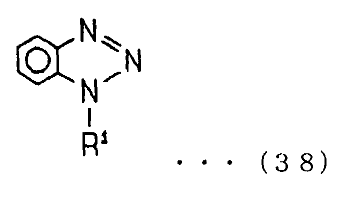

The benzotriazole derivative represented by the general formula (38) in which R¹ is an alkyl group having a carboxy group includes a compound represented by the general formula (39). Specific examples of the compound represented by the general formula (39) include, for example, 1-(1,2-dicarboxyethyl)benzotriazole represented by the chemical formula (40).

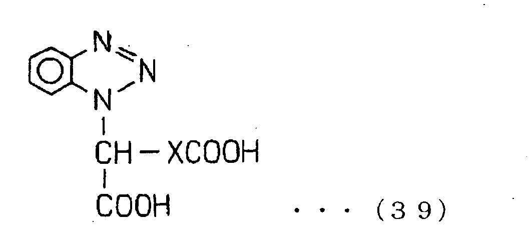

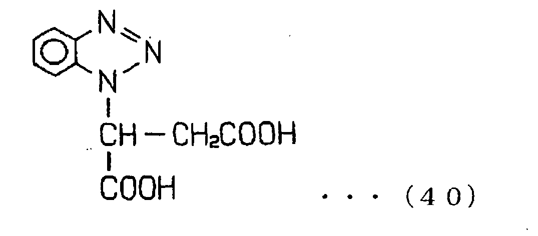

The benzotriazole derivative represented by the general formula (38) in which R¹ is an alkyl group having a hydroxy group and a tertiary amino group includes a compound represented by the general formula (41). Specific examples of the compound represented by the general formula (41) include, for example, 1-[N,N-bis(hydroxyethyl)aminomethyl]benzotriazole represented by the chemical formula (42).

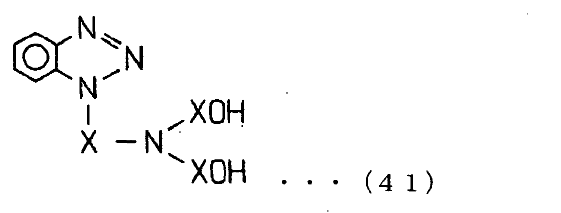

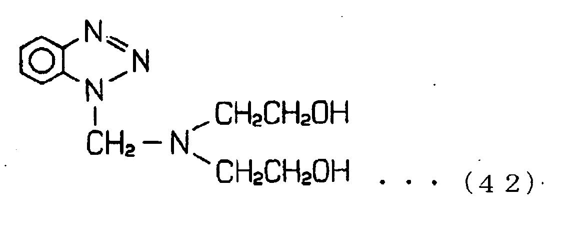

The benzotriazole derivative represented by the general formula (38) in which R¹ is an alkyl group having a hydroxy group includes a compound represented by the general formula (43) and a compound represented by the general formula (44). Specific examples of the compound represented by the general formula (43) and the compound represented by the general formula (44) include, for example, 1-(2,3-dihydroxypropyl)benzotriazole represented by the chemical formula (45) and 1-(hydroxymethyl)benzotriazole represented by the chemical formula (46).

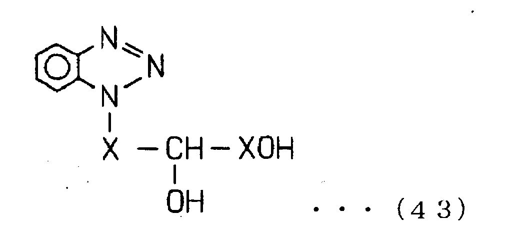

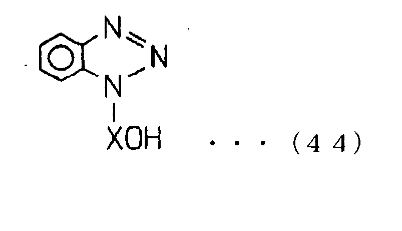

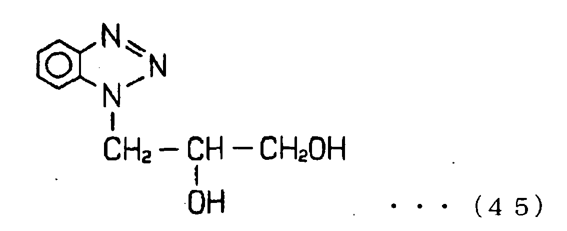

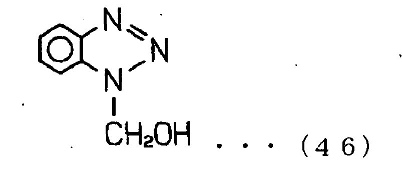

In the general formulae (39), (41), (43) and (44), X represents an alkylene group.

The second polishing composition may contain two or more kinds of anticorrosives. Among the aforementioned anticorrosives, 1-[N,N-bis(hydroxyethyl)aminomethyl]benzotriazole represented by the chemical formula (42) is the most preferable because of its particularly strong effect for protecting the surface of the conductive layer 15.

The content of the anticorrosive in the second polishing composition is preferably 0.001 to 3% by mass, and more preferably 0.01 to 0.3% by mass. If the content of the anticorrosive in the second polishing composition is less than 0.001% by mass, there is a possibility that the rough surface occurs on the surface of the conductive layer after polishing of the depth of dishing increased because the effect for protecting the surface of the conductive layer 15 and effect for inhibiting the occurrence of dishing are insufficient. If the content of the anticorrosive in the second polishing composition is more than 3% by mass, there is a possibility that the ability of the second polishing composition for polishing the conductive layer 15 will be insufficient.

The component (j), that is, the completely saponified polyvinyl alcohol has an effect for inhibiting the occurrence of a difference in level on the surface of the object to be polished after polishing by using the second polishing composition. The completely saponified polyvinyl alcohol is a polyvinyl alcohol which can be prepared by saponifying (hydrolyzing) polyvinyl acetate and has a saponification degree of 98.0% by mole or more. The completely saponified polyvinylalcohol has generally a molecular weight of about 10000 to 500000, and preferably 100000 or less because of good solubility in water.

The content of the completely saponified polyvinyl alcohol in the second polishing composition is preferably 0.001 to 1.0% by mass, and more preferably 0.005 to 0.5% by mass. If the content of the completely saponified polyvinyl alcohol is less than 0.001% by mass and more than 1.0% by mass, there is a possibility that the depth of dishing will be increased. The second polishing composition is improved in ability to polish the conductive layer 15 in proportion with increased content of the completely saponified polyvinyl alcohol.

The component (f), that is, water has a role as a medium for dissolving or dispersing the components other than water in the second polishing composition. Preferably the water contains as little as possible impurities. Specifically, the water includes pure water or ultrapure water prepared by removing impurity ions with an ion exchange resin followed by removing foreign substances through a filter, or distilled water.

The second polishing composition has preferably a pH of 1.5 to 4, and more preferably from 2 to 3. If the second polishing composition has a pH of less than 1.5, handling ability of the second polishing composition is lowered. If the second polishing composition has a pH of more than 4, there is a possibility that it will have insufficient ability to polish the barrier layer 14. The second polishing composition may be regulated by increasing or decreasing the acid content.

The second polishing composition is prepared by adding the components (g) to (j) to water, followed by mixing. For mixing, a blade-type agitator, an ultrasonic dispersing apparatus, or the like may be employed. The order of addition of the components (g) to (j) to the water is not limited.

The second polishing composition may further comprise an oxidizing agent. The oxidizing agent has an effect for oxidizing the copper-containing metal, thereby to accelerate the mechanical polishing of the conductive layer 15 with the colloidal silica. The oxidizing agent may be hydrogen peroxide, nitric acid, potassium permanganate, or a persulfate salt, and among them, hydrogen peroxide is preferable because of its high oxidizing ability.

When an oxidizing agent is contained, its content in the second polishing composition is preferably 0.1 to 20% by mass, and more preferably 0.1 to 5% by mass. If the content of the oxidizing agent in the second polishing composition is less than 0.1% by mass, the second polishing composition is not so improved in ability to polish the object to be polished. If the content of the oxidizing agent in the second polishing composition is more than 20% by mass, there is a possibility that the depth of dishing will be increased.

When the second polishing composition contains an oxidizing agent, the second polishing composition may be prepared or stored in such a condition that the oxidizing agent and the other components are separated. In this case, the second polishing composition is prepared by admixing the oxidizing agent and the other components immediately before the use. Thereby, it is possible to inhibit the decomposition of the oxidizing agent in the second polishing composition during storage.

The second polishing composition may further contain, as necessary, a thickener, an antifoaming agent, a preservative, and the like.

When carrying out the chemical polishing in the second polishing step by using the second polishing composition, a polishing pad is pressed to the surface of the conductive layer 15 and rotated while supplying the polishing composition to the surface of the conductive layer 15.

According to the first embodiment, the following advantages are provided.

The depth of dishing at the end of the first polishing step is reduced due to the effects of the surfactant and the anticorrosive in the first polishing composition. The depth of erosion at the end of the first polishing step is reduced by using the first polishing composition in the chemical mechanical polishing of the first polishing step. Therefore, according to the first polishing composition, the occurrence of dishing and erosion are inhibited during the first polishing step. In addition, the first polishing composition is excellent in ability to polish the conductive layer 15 due to the effects of the carboxylic acid and the oxidizing agent.

The depth of dishing and the depth of erosion at the end of the second polishing step are reduced due to the effects of the completely saponified polyvinyl alcohol in the second polishing composition. Therefore, according to the second polishing composition, the occurrence of dishing and erosion are inhibited during the second polishing step. In addition, the second polishing composition is excellent in ability to polish the barrier layer 14 due to the effects of the colloidal silica and the acid. It is assumed that the completely saponified polyvinyl alcohol can weaken adequately the ability of the second polishing composition for polishing the object to be polished, thereby inhibiting the occurrence of dishing and erosion which causes a difference in surface levels. A partially saponified polyvinyl alcohol does not possess the effect for inhibiting the occurrence of dishing and erosion, such effect being inherent in the completely saponified polyvinyl alcohol.

At the end of the first polishing step, in some cases, there remains a portion of the conductive layer 15 positioned outside the trench 13 in a large amount. In such a case, it is necessary, in chemical mechanical polishing of the second polishing step, to remove not only the barrier layer 14 but also the largely remaining conductive layer 15. As mentioned above, the second polishing composition is improved in ability to polish the conductive layer 15 in proportion with increased content of the completely saponified polyvinyl alcohol. Therefore, the second polishing composition is regulated in content of the completely saponified polyvinyl alcohol in accordance with the amount of the remaining portion of the conductive layer 15 positioned outside the trench 13 at the end of the first polishing step, allowing favorable chemical mechanical polishing in the second polishing step.

The second polishing composition, which contains a mixture of the first colloidal silica having an average particle size of not less than 0.05 µm and not more than 0.3 µm and the second colloidal silica having an average particle size of not less than 0.01 µm and less than 0.05 µm, is improved both in ability to polish the insulating layer 12 due to the effect of the first colloidal silica and in ability to polish the barrier layer 14 due to the effect of the second colloidal silica. As a result, the chemical mechanical polishing in the second polishing step is improved in efficiency. The second polishing composition containing the first colloidal silica and the second colloidal silica is particularly useful for polishing the uneven device surface found at the end of the first polishing step, because it has high abilities not only to polish the barrier layer 14 but also to polish the insulating layer 12.

The second embodiment of the present invention is explained as follows.

A first polishing composition in accordance with the second embodiment is different from the first polishing composition in accordance with the first embodiment. The first polishing composition in accordance with the second embodiment contains a component (A) comprising an α-amino acid, a component (B) comprising a benzotriazole derivative, a component (C) comprising a silicon oxide, a component (D) comprising a surfactant, a component (E) comprising an oxidizing agent, and a component (F) comprising water.

The component (A), that is, α-amino acid has an effect for forming a chelate bond with copper, and thereby, contributes to improving the ability of the first polishing composition for polishing the conductive layer 15. The α-amino acid also has an effect for reducing the depth of dishing. Specific examples of the α-amino acid are, for example, alanine, glycine, and valine. Among them, alanine is preferable because of its strong effect for reducing the depth of a dishing and good water solubility. The first polishing composition may contain two or more kinds of α-amino acids.

The content of the α-amino acid in the first polishing composition is 0.01 to 2% by mass, and more preferably 0.4 to 1.5% by mass. If the first polishing composition has an α-amino acid content of less than 0.01% by mass, there is a possibility that the composition will have a weakened effect for reducing the depth of dishing, thereby increasing the dishing depth. If the first polishing composition has an α-amino acid content of more than 2% by mass, there is a possibility that the composition will be reduced in ability for polishing the conductive layer 15 due to high concentration of the α-amino acid.

The component (B), that is, the benzotirazole derivative is represented by the aforementioned general formula (28). The benzotriazole derivative has an effect for protecting the copper-containing metal from corrosion caused by the oxidizing agent, thereby preventing the surface of the conductive layer 15 from corrosion. In addition, the anticorrosive has an effect for inhibiting excess polishing of the conductive layer 15, thereby inhibiting occurrence of dishing. Specific examples of the benzotriazole derivative are, for example, the compounds represented by the aforementioned general formula (29) including 1-(1,2-dicarboxyethyl)benzotriazole, the compounds represented by the aforementioned general formula (31) including 1-[N,N-bis(hydroxyethyl)aminomethyl]benzotriazole, and the compounds represented by the aforementioned general formula (33) or (34) including 1-(2,3-dihydroxypropyl)benzotriazole and 1-(hydroxymethyl)benzotriazole.

The first polishing composition has preferably a benzotriazole derivative content of 0.1% by mass or less. When the benzotriazole derivative is a compound represented by the general formula (29), the first polishing composition has preferably a benzotriazole derivative content of 0.0005 to 0.01% by mass, and more preferably 0.002 to 0.008% by mass. When the benzotriazole derivative is a compound represented by the general formula (31), the first polishing composition has preferably a benzotriazole derivative content of 0.00005 to 0.005% by mass, and more preferably 0.0001 to 0.001% by mass. When the benzotriazole derivative is a compound represented by the general formula (33) or (34), the first polishing composition has preferably a benzotriazole derivative content of 0.001 to 0.1% by mass, and more preferably 0.003 to 0.005% by mass.

If the content of the benzotriazole derivative is too small, there is a possibility that the rough surface of the conductive layer 15 after the polishing occurs or the depth of dishing will be increased due to insufficient effect for protecting the surface of the conductive layer 15 and for inhibiting the generation of dishing. If the content of the benzotriazole derivative is too large, there is a possibility that some of the conductive layer 15 to be removed will remain on the insulating layer 12 after the polishing due to insufficient ability of the first polishing composition to polish the copper-containing metal.

Since the component (C), that is, the silicon oxide is the same as the silicon oxide in the first polishing composition of the first embodiment, an explanation thereof is omitted.

The component (D), that is, the surfactant has an effect for inhibiting the occurrence of dishing by reducing the depth of dishing. Specific examples of the surfactant include, for example, coconut oil fatty acid sarcosine triethanolamine represented by the aforementioned chemical formula (18), coconut oil fatty acid methyl taurin sodium represented by the aforementioned chemical formula (19), and sodium polyoxyethylene coconut oil fatty acid monoethanolamide sulfate represented by the aforementioned chemical formula (20), polyoxyethylene alkylphenyl ether phosphate represented by the aforementioned chemical formula (21), and dodecylbenzene sulfonic acid triethanolamine represented by the aforementioned chemical formula (22), disodium polyoxyethylene alkyl sulfosuccinate represented by the aforementioned chemical formula (23) and a dioctyl-series sulfosuccinic acid salt represented by the aforementioned chemical formula (24), polyoxyethylene lauryl ether sulfate triethanolamine represented by the aforementioned chemical formula (25), and diisobutyldimethylbutynediol polyoxyethylene glycol ether represented by the aforementioned chemical formula (26).

The content of the surfactant in the first polishing composition is preferably 0.025 to 0.2% by mass, and more preferably 0.03 to 0.1% by mass. If the first polishing composition has a surfactant content of less than 0.025% by mass, there is a possibility that occurrence of dishing will not be inhibited because the depth of dishing is not reduced. If the first polishing composition has a surfactant content of more than 0.2% by mass, there is a possibility that some of the conductive layer 15 to be removed will remain on the insulating layer 12 after the polishing due to strong inhibition of polishing of the copper-containing metal.

Since the component (E), that is, the oxidizing agent is the same as the oxidizing agent in the first polishing composition of the first embodiment, explanation thereof is omitted.

Since the component (F), that is, water is the same as water in the first polishing composition of the first embodiment, explanation thereof is omitted.

According to the second embodiment, the following advantages are obtained.

The depth of dishing found at the end of the first polishing step is reduced due to the effects of the α-amino acid, the benzotriazole derivative and the surfactant in the first polishing composition. The depth of erosion found at the end of the first polishing step is reduced by using the first polishing composition in the chemical mechanical polishing of the first polishing step. Therefore, like the first polishing composition in the first embodiment, the first polishing composition in the second embodiment also can inhibit the occurrence of dishing during the first polishing step. In addition, the first polishing composition is excellent in ability for polishing the conductive layer 15 due to the effects of the α-amino acid and the oxidizing agent.

The aforementioned embodiment may be modified as follows.

The first polishing composition and the second polishing composition may be prepared by diluting the original stock solution with water, respectively. To the original stock solution of the second polishing composition, a dispersion stabilizer is preferably added in order to inhibit agglomeration of the colloidal silica.

The chemical mechanical polishing of the first polishing step may be carried out by dividing the step into two sub steps. For example, the chemical mechanical polishing of the first polishing step may be carried out by two divided sub steps as follows: a first sub step where, as shown in Fig. 1(b), one part of the portion of the conductive layer 15 positioned outside the trench 13 is removed by the chemical mechanical polishing in order to almost eliminate the initial recess 16; and a second sub step where, as shown in Fig. 1(c), another part of the portion of the conductive layer 15 positioned outside the trench 13 is removed by the chemical mechanical polishing in order to expose the upper surface of the barrier layer 14. In this case, in both the first sub step and the second sub step, both the first polishing composition in accordance with the first embodiment and the first polishing composition in accordance with the second embodiment may be used. When the first polishing composition in accordance with the first or second embodiment is used in the chemical mechanical polishing of the second sub step, the other polishing composition than the first polishing composition in accordance with the first or second embodiment may be used as a polishing composition for the chemical mechanical polishing in the first sub step. The other polishing composition than the first polishing composition in accordance with the first or second embodiment used in the chemical mechanical polishing in the first sub step may be a composition comprising any one of silicon oxide and aluminum oxide, any one of glycine and α-alanine, and hydrogen peroxide, and water.

The second polishing composition may be used in the chemical mechanical polishing of the first polishing step. In this case, the second polishing composition has preferably a completely saponified polyvinyl alcohol content of 0.005% by mass or more, and more preferably 0.01% by mass or more. The second polishing composition having a completely saponified polyvinyl alcohol content set as mentioned above is improved in ability to polish the copper-containing metal (conductive layer 15).

In the following, Examples and Comparative examples of the present invention are described.

In order to prepare first polishing compositions in accordance with Examples 1 to 31 and Comparative Examples 1 to 11, the components shown in Table 1 and Table 2 were mixed with water. The pH values of the first polishing compositions in accordance with Examples 1 to 31 and Comparative Examples 1 to 11 were measured. The results are shown in Table 1 and

Table 2.

Copper blanket wafers were polished by using the first polishing compositions in accordance with Examples 1 to 31 and Comparative Examples 1 to 11 under the first polishing conditions. The copper blanket wafer is prepared by forming a copper layer on an 8 inch silicon wafer by electrolytic plating. The thickness of the copper blanket wafer before and after the polishing was measured by using a sheet type resistor machine "VR-120" available from KOKUSAI DENKI SYSTEM SERVICE Co. Ltd. A reduction in thickness of the wafer by polishing was calculated from the measured thickness of the wafer before and after the polishing. The polishing rate, which is obtained by dividing the thus calculated thickness reduction by polishing time, is shown in the column entitled "Polishing rate" of Table 1 and Table 2.

### <FIRST POLISHING CONDITIONS>

Polishing machine: Single-side type CMP machine "Mirra" available from Applied Materials Co. Ltd.,
Polishing pad: Laminated polishing pad "IC-1000/Suba400" made of polyurethane available from Rodel Co.,
Polishing pressure: 2 psi (= about 13.8 kPa),
Platen rotational speed: 60 rpm,
First polishing composition feed rate: 200 ml/min.,
Carrier rotational speed: 60 rpm
Polishing time: 1 min.

A copper patterned wafer was polished by using a polishing slurry, "PLANERLITE-7102," available from FUJIMI INCORPORATED under the second polishing conditions. The copper patterned wafer is a copper patterned wafer with a 1000 nm thick copper layer (854 mask pattern) available from SEMTECH Co. Ltd., and has a 800 nm deep initial recess 16. The polishing was terminated at the time when the copper layer of the copper patterned wafer was polished to a 70% reduction in thickness. This process corresponds to the chemical mechanical polishing process of the first sub step in the first polishing step. Next, the copper patterned wafer subjected to the chemical mechanical polishing process of the first sub step was polished by using each of the first polishing compositions in accordance with Examples 1 to 31 and Comparative Examples 1 to 11 under the first polishing conditions. The barrier layer 14 thus polished, the upper surface of which was detected to expose itself by an indicating endpoint, was additionally polished for another period of time necessary to polish out a 200 nm thick copper layer, followed by finishing the polishing. This process corresponds to the chemical mechanical polishing process of the second sub step in the first polishing step. Thereafter, a region with 100 µm wide wiring 17 formed thereon was measured for the depth of dishing. The depth of dishing was measured by using a contact type surface measuring apparatus of profiler, "HRP340", available from KLA-Tencol Co. The results of the measurement are shown in the column entitled "Depth of dishing" of Table 1 and Table 2. In the column, "-" (hyphen) represents the fact that the depth of dishing could not be measured because the wafer was not polished.

With respect to the copper patterned wafer subjected to the chemical mechanical polishing processes of the first sub step and the second sub step, copper-containing metal remaining on the region of the insulating layer 12 with no wiring 17 formed thereon was measured for the amount remaining. The amount of the copper-containing metal left was measured by using a differential interference microscope "OPTIPHOT0300" available from NIKON Co. Ltd. On the basis of the thus measured amount of the copper-containing metal left, each of the first polishing compositions in accordance with Examples 1 to 31 and Comparative Examples 1 to 11 was evaluated based on four levels: Excellent (⊚), Good (○), Pass (Δ) and Poor (×). Namely, a case where no copper-containing metal was found left was evaluated as Excellent, a case where a spotted copper-containing metal was found slightly left was evaluated as Good, a case where a spotted copper-containing metal was found left throughout was evaluated as Pass, and a case where too large amount of the copper-containing metal was found left to confirm wiring was evaluated as Poor. The results of the evaluation are shown in the column entitled "Amount of copper-containing metal left" of Table 1 and Table 2.

### <SECOND POLISHING CONDITIONS>

Polishing machine: Single-side type CMP machine "Mirra" available from Applied Materials Co. Ltd.,
Polishing pad: Multi-layered polishing pad "IC-1000-1400" made of polyurethane available from Rodel Co.,
Polishing pressure: 2.0 psi (= about 13.8 kPa),
Platen rotational speed: 100 rpm,
First polishing composition feed rate: 200 ml/min.,
Carrier rotational speed: 100 rpm

The copper blanket wafers were polished under the first polishing conditions by using the first polishing compositions in accordance with Examples 1 to 31 and Comparative Examples 1 to 11 immediately after preparation and the first polishing compositions in accordance with Examples 1 to 31 and Comparative Examples 1 to 11 after storing in a closed container for a while after preparation, respectively. Each polishing rate was calculated from the thickness of the wafer before and after the polishing, and on the basis of degree of lowering by the storage in polishing rate of each first polishing composition, a pot life for each of the first polishing compositions in accordance with Examples 1 to 31 and Comparative Examples 1 to 11 was evaluated based on four levels: Excellent (⊚), Good (○), Pass (Δ) and Poor (×). Namely, a case where the polishing rate provided by the first polishing composition stored for two weeks or more was larger than 90% of the polishing rate provided by the first polishing composition immediately after preparation was evaluated as Excellent, a case where the polishing rate provided by the first polishing composition stored for one week or more and less than two weeks was less than 90% of the polishing rate provided by the first polishing composition immediately after preparation was evaluated as Good, a case where the polishing rate provided by the first polishing composition stored for three days or more and less than one week was less than 90% of the polishing rate provided by the first polishing composition immediately after preparation was evaluated as Pass, and a case where the polishing rate obtained by the first polishing composition stored for less than three days is less than 90% of the polishing rate provided by the first polishing composition immediately after preparation was evaluated as Poor. The results of the evaluation are shown in the column entitled "Pot life" of Table 1 and Table 2.

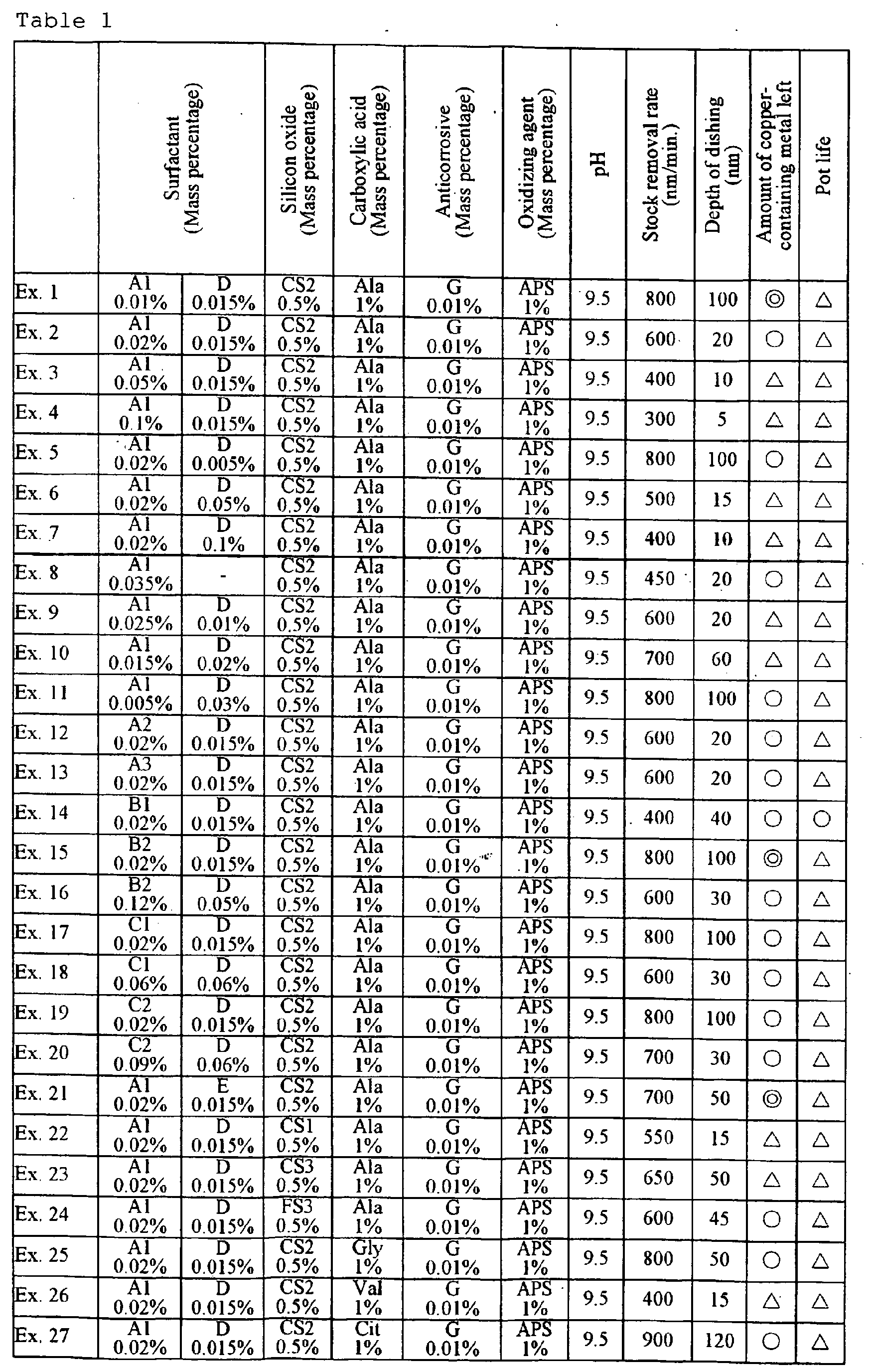

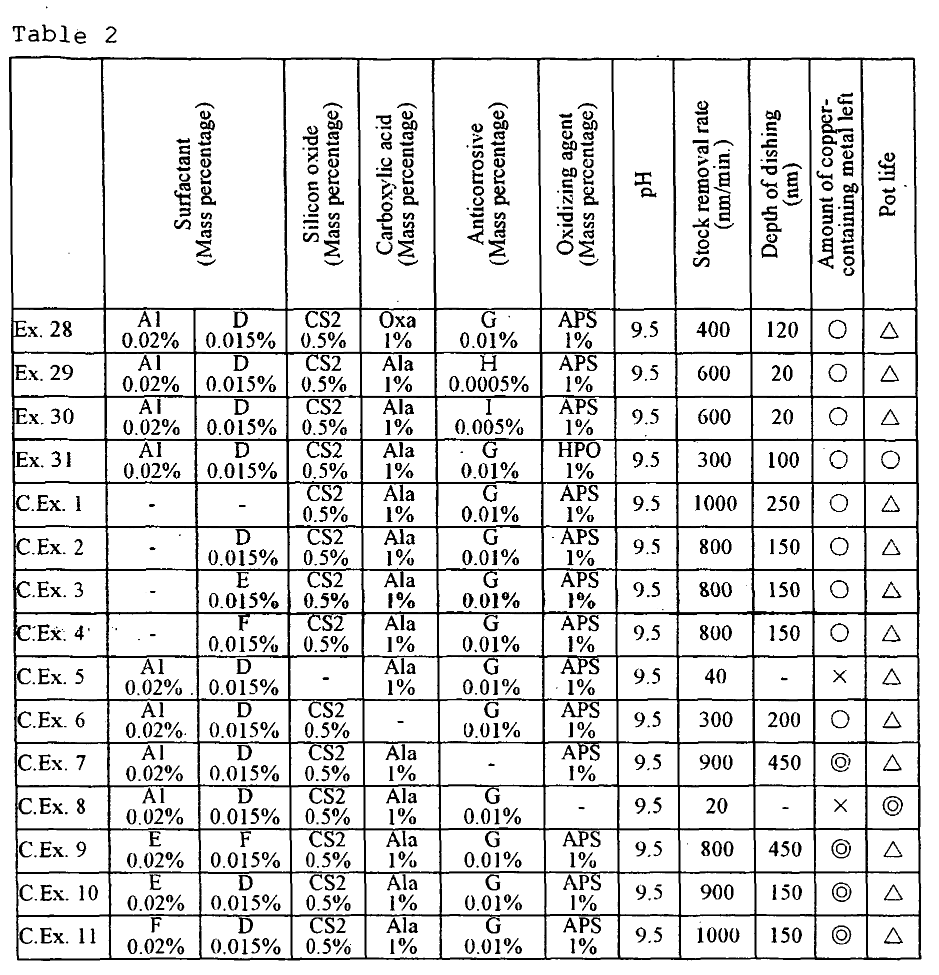

In the column entitled "Surfactant" of Table 1 and Table 2,
A1 is coconut oil fatty acid sarcosine triethanolamine,
A2 is coconut oil fatty acid methyl taurin sodium,
A3 is sodium polyoxyethylene coconut oil fatty acid monoethanolamide sulfate,
B1 is polyoxyethylene alkyl phenyl ether phosphate,
B2 is dodecylbenzene sulfonic acid triethanolamine,
C1 is disodium polyoxyethylene alkyl sulfosuccinate,
C2 is sulfosuccinic acid salt,
D is polyoxyethylene lauryl ether sulfate triethanolamine,
E is diisobutyldimethylbutinediol polyoxyethylene glycol ether, and
F is polyoxyethylene polyoxypropylene alkyl ether represented by the chemical formula (97).

HO-(CH₂CH₂O)_{w}-(CH₂CH(CH₃)O)ₓ-(CH₂CH₂O)_{y}-H (47)

In the chemical formula (47), the sum of w and y is 164, and x is 31.

In the column entitled "Silicon oxide" of Table 1 and Table 2,
CS1 is colloidal silica having an average particle size D_{N4} of 0.03 µm,
CS2 is colloidal silica having an average particle size D_{N4} of 0.04 µm,
CS3 is colloidal silica having an average particle size D_{N4} of 0.07 µm, and
FS3 is a fumed silica having an average particle size D_{N4} of 0.07 µm.

The average particle size D_{N4} of the silicon oxide was measured by using an N4 Plus Submicron Particle Sizer available from Beckman Coulter, Inc. The sum of amounts of iron, nickel, copper, chromium, zinc and calcium in a 20% by mass aqueous solution of the colloidal silica was not more than 20 ppb.

In the column entitled "Carboxylic acid" in Table 1 and Table 2,
Ala is alanine,
Gly is glycine,
Val is valine,
Cit is citric acid, and
Oxa is oxalic acid.

In the column entitled "Anticorrosive" in Table 1 and Table 2,
G is 1-(2,3-dihydroxypropyl)benzotriazole,
H is 1-[N,N-bis(hydroxydimethyl)aminomethyl]-benzotriazole, and
I is 1-(1,2-dicarboxyethyl)benzotriazole.

In the column entitled "Oxidizing agent" in Table 1 and Table 2,
APS is ammonium persulfate, and
HPO is hydrogen peroxide.

As shown in Table 1 and Table 2, in Examples 1 to 31, it was found that the depth of dishing was small, and the occurrence of dishing was inhibited. Also, it was found that the first polishing compositions of Examples 1 to 31 had high ability for polishing the copper-containing metal. The first polishing compositions of Examples 1 to 4 which contained the compound selected from the first group in an amount of 0.05 to 0.1% by mass, and the first polishing compositions of Examples 5 to 7 which contained the compound selected from the second group in an amount of 0.05 to 0.1% by mass had ability for polishing the copper-containing metal, and could also reduce the depth of dishing remarkably.

In order to prepare second polishing compositions in accordance with Examples 32 to 72 and Comparative Examples 12 to 26, the components shown in Table 3 to Table 5 were mixed with water. The pH values of the second polishing compositions in accordance with Examples 32 to 72 and Comparative Examples 12 to 26 were measured. The results are shown in Table 3 to Table 5.

A copper patterned wafer (854 mask pattern) available from SEMTECH Co. Ltd. was polished by using a polishing slurry, " PLANERLITE-7102", available from FUJIMI INCORPORATED under the aforementioned second polishing conditions. The polishing was terminated at the time when the thickness of the copper layer of the copper patterned wafer after polishing was 70% of the thickness of the copper layer of the copper patterned wafer before polishing. This process corresponds to the chemical mechanical polishing process of the first sub step in the first polishing step. Next, the copper patterned wafer subjected to the chemical mechanical polishing process of the first sub step was polished by using the first polishing composition in accordance with Example 2 under the aforementioned first polishing conditions. The barrier layer 14 thus polished, the upper surface of which was detected to expose itself by an indicating endpoint, was additionally polished for another period of time necessary to polish out a 200 nm thick copper layer, followed by finishing the polishing. This process corresponds to the chemical mechanical polishing process of the second sub step in the first polishing step. Subsequently, the copper patterned wafer subjected to the chemical mechanical polishing process of the second sub step was polished by using each of the second polishing compositions in accordance with Examples 32 to 72 and Comparative Examples 12 to 26 under the third polishing conditions. This process corresponds to the chemical mechanical polishing process of the second sub step in the second polishing step. At the end of the second sub step and the end of the second polishing step, a region with a 100 µm wide wiring 17 formed was measured for the depth of dishing. The depth of dishing was measured by using a contact type surface measuring apparatus of profiler, "HRP340", available from KLA-Tencol Co. On the basis of difference calculated by taking out the depth of dishing measured at the end of the second polishing step from the depth of dishing measured at the end of the second sub step, each of the second polishing compositions in accordance with Examples 32 to 72 and Comparative Examples 12 to 26 were evaluated based on four levels: Excellent (⊚), Good (○), Pass (Δ) and Poor (×). Namely, a case where the difference was 0 nm or more was evaluated as Excellent, a case where the difference was from - 10 nm or more and less than 0 nm was evaluated as Good, a case where the difference was from -20 nm or more and less than -10 nm was evaluated as Pass, and a case where the difference was less than -20 nm was evaluated as Poor. The results of the evaluation are shown in the column entitled "Surface difference" of Table 3 to Table 5.

### <Third polishing conditions>

Polishing machine: Single-side type CMP machine "Mirra" available from Applied Materials Co. Ltd.,
Polishing pad: Multi-layered polishing pad "IC-1000/Suba400" made of polyurethane available from Rodel Co.,
Polishing pressure: 2 psi (= about 13.8 kPa),
Platen rotational speed: 80 rpm,
Second polishing composition feed rate: 200 ml/min.,
Carrier rotational speed: 80 rpm,
Polishing time: 1 min.

The copper patterned wafer subjected to the chemical mechanical polishing process of the second polishing step as mentioned above, the copper blanket wafer polished by using each of the second polishing compositions in accordance with Examples 32 to 72 and Comparative Examples 12 to 26 under the third polishing conditions and a silicon dioxide blanket wafer were prepared. The copper blanket wafer was prepared by forming a copper layer on an 8 inch silicon wafer by electrolytic plating. The silicon dioxide blanket wafer was prepared by forming a silicon dioxide layer on an 8 inch silicon wafer by CVD method by using TEOS as a starting material. The prepared wafers were cleaned in pure water by ultrasonic cleaning (40 kHz) for one minute, and additionally scrub-cleaned with pure water to which a cleaning agent "SD3000" available from MITSUBISHI Chemical Co. Ltd. was added. The wafers after cleaned were rinsed with pure water, and then spin-dried. Particles (foreign substances) having a size of not less than 0.25 µm existing on the copper patterned wafer after polishing were counted in number by using a wafer defect detecting apparatus with dark-field.pattern "AIT III" available from KLA Tencol Co. Further, particles (foreign substances) having a size of not less than 0.25 µm existing on the copper blanket wafer and the silicon dioxide blanket wafer after polishing were counted in number by using a wafer surface foreign substance detecting apparatus without pattern "SPI-TBI" available from KLA Tencol Co., respectively. On the basis of the thus counted number of particles on each of the wafers, each of the second polishing compositions in accordance with Examples 32 to 72 and Comparative Examples 12 to 26 were evaluated based on four levels: Excellent (⊚), Good (○), Pass (Δ) and Poor (×) . Namely, a case where the number of particles counted on the copper patterned wafer was not more than 600, the number of particles counted on the copper blanket wafer was not more than 250, and the number of particles counted on the silicone dioxide blanket wafer was not more than 100 was evaluated as Excellent, a case where the number of particles counted on the copper patterned wafer was not less than 601 and not more than 1000, the number of particles counted on the copper blanket wafer was not less than 251 and not more than 500, and the number of particles counted on the silicone dioxide blanket wafer was not less than 101 and not more than 200 was evaluated as Good, a case where the number of particles counted on the copper patterned wafer was not less than 1001 and not more than 2000, the number of particles counted on the copper blanket wafer was not less than 501 and not more than 1000, and the number of particles counted on the silicone dioxide blanket wafer was not less than 201 and not more than 400 was evaluated as Pass, and a case where the number of particles counted on the copper patterned wafer was not less than 2001, the number of particles counted on the copper blanket wafer was not less than 1001, and the number of particles counted on the silicone dioxide blanket wafer was not less than 401 was evaluated as Poor. The results of the evaluation are shown in the column entitled "Cleaning property" of Table 3 to Table 5.

One hundred particles were randomly selected from those on the copper patterned wafer, the copper blanket wafer and the silicon dioxide blanket wafer after cleaning and drying. The selected particles were analyzed as to whether they correspond to surface defects of the wafer or not. The number of particles corresponding to surface defects in the selected 100 particles was calculated by percentage. On the basis of the thus calculated percentage, each of the second polishing compositions in accordance with Examples 32 to 72 and Comparative Examples 12 to 26 were evaluated based on four levels: Excellent (⊚), Good (○), Pass (Δ) and Poor (×). Namely, a case where the percentage of the number of particles corresponding to surface defects was less than 5% was evaluated as Excellent, a case where the percentage was not less than 5% and less than 10% was evaluated as Good, a case where the percentage was not less than 10% and less than 20% was evaluated as Pass, and a case that the percentage was not less than 20% was evaluated as Poor. The results of the evaluation are shown in the column entitled "Surface defect" of Table 3 to Table 5.

The silicon dioxide blanket wafers were polished under the third polishing conditions by using the second polishing compositions in accordance with Examples 32 to 72 and Comparative Examples 12 to 26 immediately after preparation and the second polishing compositions in accordance with Examples 32 to72 and Comparative Examples 12 to 26 after storage in a 43°C constant temperature bath for a while after preparation, respectively. Each polishing rate was calculated from the thickness of the wafer before and after the polishing, and on the basis of degree of lowering of the polishing rate of each first polishing composition due to the storage, the stability of the second polishing compositions in accordance with Examples 32 to 72 and Comparative Examples 12 to 26 was evaluated based on four levels: Excellent (Ⓞ), Good (O), Pass (Δ) and Poor (×). Namely, a case where the polishing rate provided by the second polishing composition after storage for two months or more was larger than 90% of the polishing rate provided by the second polishing composition immediately after preparation was evaluated as Excellent, a case where the polishing rate provided by the second polishing composition after storage for not less than one month and less than two months was less than 90% of the polishing rate provided by the second polishing composition immediately after preparation was evaluated as Good, a case where the polishing rate provided by the second polishing composition after storage for not less than one week and less than one month was less than 90% of the polishing rate provided by the second polishing composition immediately after preparation was evaluated as Pass, and a case where the polishing rate provided by the second polishing composition after storage for less than one week was less than 90% of the polishing rate provided by the second polishing composition immediately after preparation was evaluated as Poor. The results of the evaluation are shown in the column entitled "Stability" of Table 3 to Table 5.

A copper patterned wafer subjected to the chemical mechanical polishing process of the first sub step and the second sub step was polished by using each of the second polishing compositions in accordance with Examples 32 to 72 and Comparative Examples 12 to 26 under the third polishing conditions. In addition, a copper blanket wafer, a tantalum blanket wafer, a tantalum nitride blanket wafer, a silicon dioxide blanket wafer and a Black Diamond (R) blanket wafer were polished by using each of the second polishing compositions in accordance with Examples 32 to 72 and Comparative Examples 12 to 26 under the third polishing conditions. The tantalum blanket wafer was prepared by forming a tantalum layer on an 8 inch silicon wafer by sputtering method, the tantalum nitride blanket wafer was prepared by forming a tantalum nitride layer on an 8 inch silicon wafer by sputtering method. The Black Diamond (R) blanket wafer was available from Applied Materials Co. Ltd. and was prepared by forming a layer of Low-K material (material with a low dielectric constant) on an 8 inch silicon wafer. The polishing rates calculated from the thickness of each wafer before and after polishing are shown in the column entitled "Polishing rate" of Table 3 to Table 5.

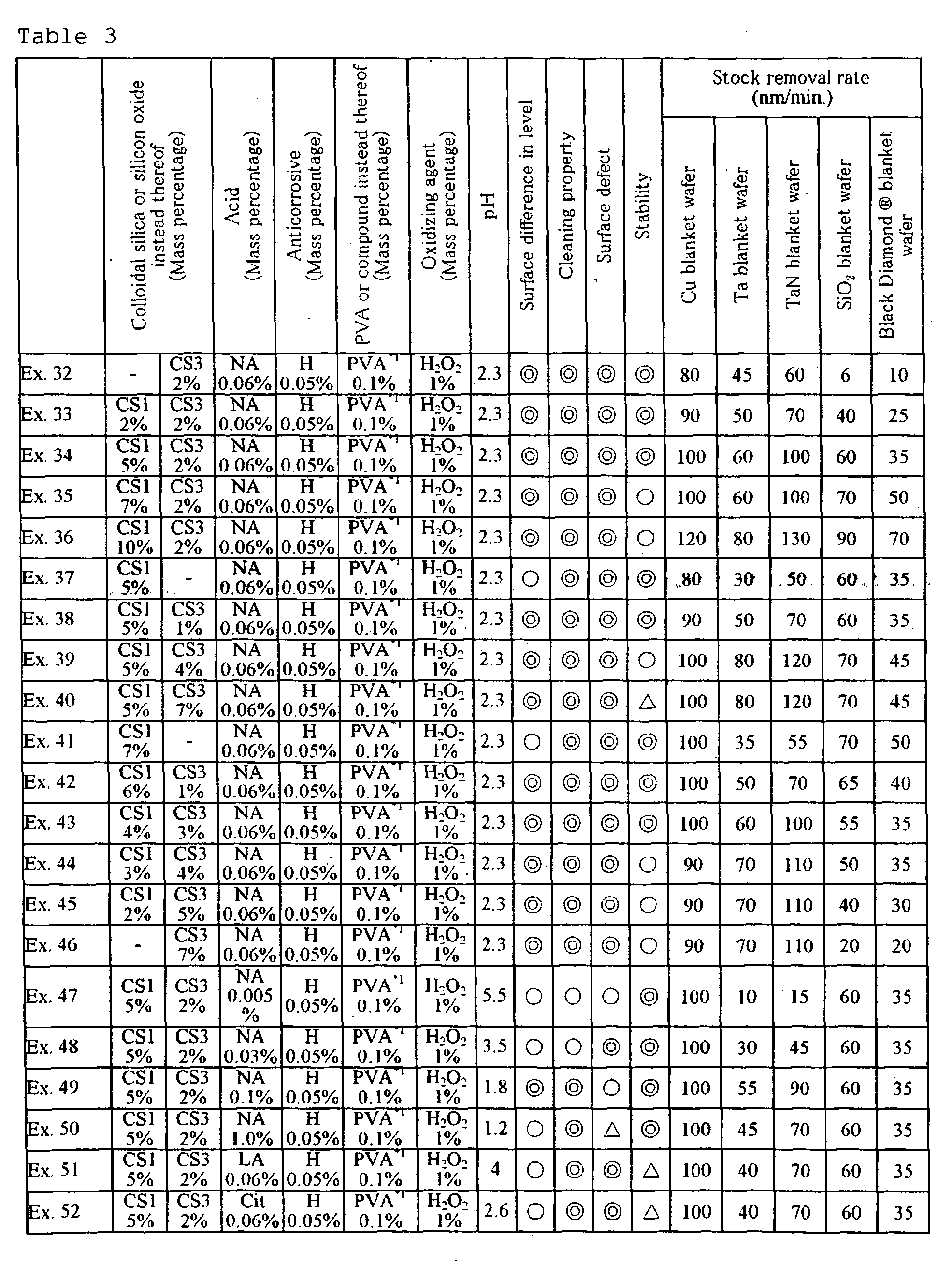

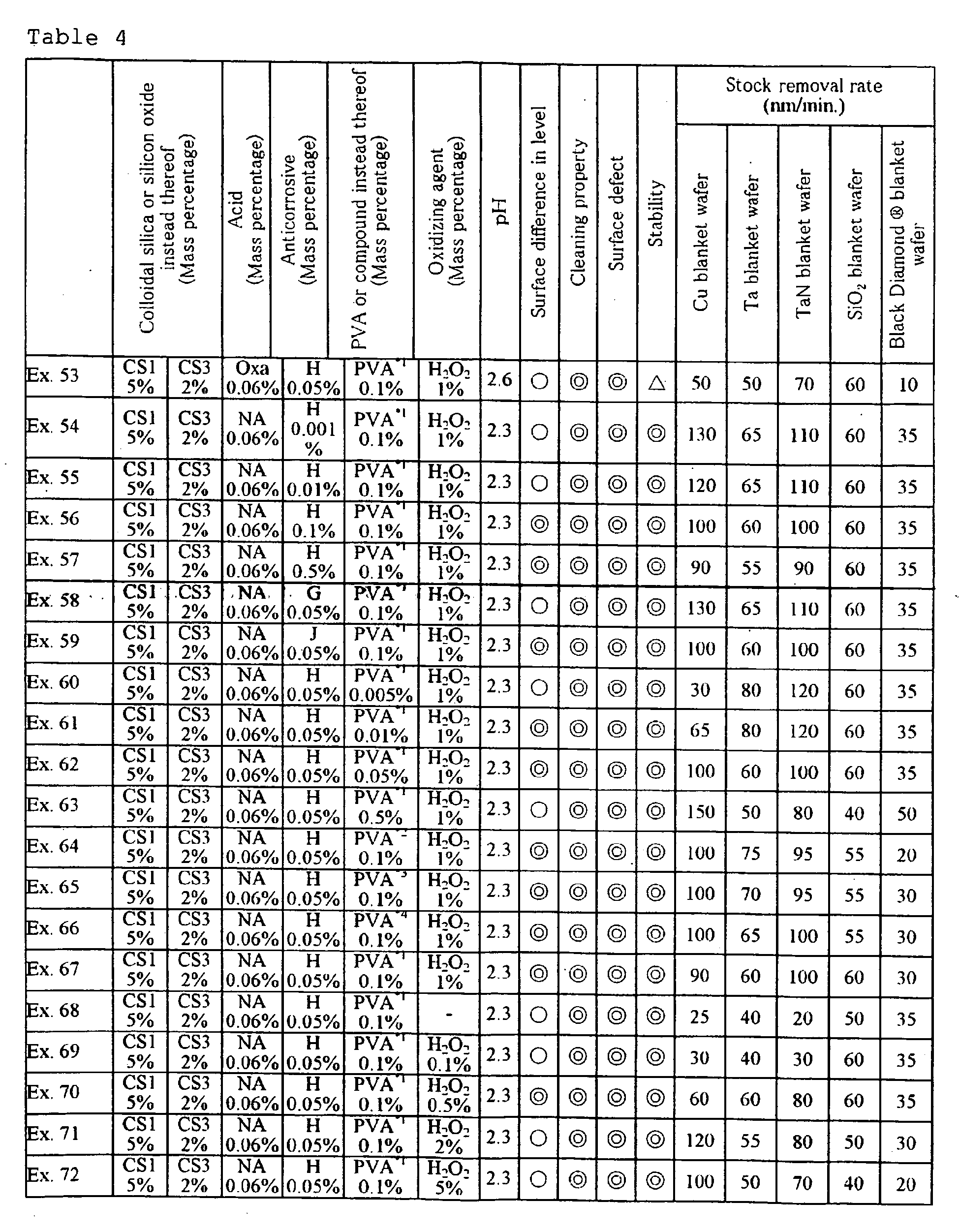

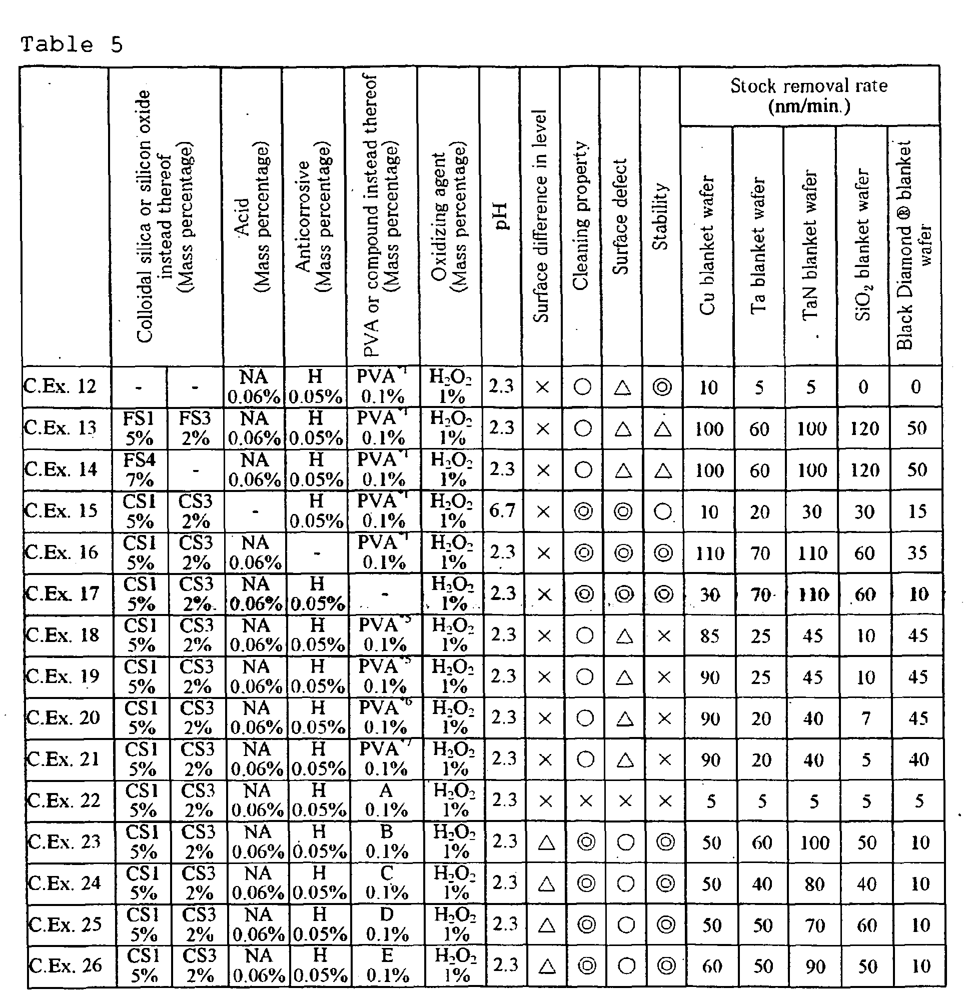

In the column entitled "Colloidal silica or silicon oxide instead thereof" of Table 3 to Table 5,
CS1 is colloidal silica having an average particle size D_{N4} of 0.03 µm,
CS3 is colloidal silica having an average particle size D_{N4} of 0.07 µm,
FS1 is a fumed silica having an average particle size D_{N4} of 0.03 µm,
FS3 is a fumed silica having an average particle size D_{N4} of 0.07 µm, and
FS3 is a fumed silica having an average particle size D_{N4} of 0.18 µm.

In the column entitled "Acid" in Table 3 to Table 5,
NA is nitric acid,
LA is lactic acid,
Cit is citric acid, and
Oxa is oxalic acid.

In the column entitled "Anticorrosive" in Table 3 to Table 5,
G is 1-(2,3-dihydroxypropyl)benzotriazole,
H is 1-[N,N-bis(hydroxydimethyl)aminomethyl]-benzotriazole, and
J is benzotriazole.

In the column entitled "PVA or compound instead thereof" of Table 3 to Table 5,
PVA^{*1} is a completely saponified polyvinyl alcohol having a molecular weight of 100,000 and a saponification degree of not less than 98%,
PVA⁺² is a completely saponified polyvinyl alcohol having a molecular weight of 10,000 and a saponification degree of not less than 98%,
PVA⁺³ is a completely saponified polyvinyl alcohol having a molecular weight of 20,000 and a saponification degree of not less than 98%,
PVA⁺⁴ is a completely saponified polyvinyl alcohol having a molecular weight of 60,000 and a saponification degree of not less than 98%,
PVA⁺⁵ is a partially saponified polyvinyl alcohol having a molecular weight of 100,000 and a saponification degree of not less than 88%,
PVA^{*6} is a partially saponified polyvinyl alcohol having a molecular weight of 20,000 and a saponification degree of not less than 88%,
PVA⁺⁷ is a partially saponified polyvinyl alcohol having a molecular weight of 60,000 and a saponification degree of not less than 88%,
A is polyethylene glycol,
B is polyacrylic acid,
C is ammonium lauryl sulfate,
D is polyoxyethylene polyoxypropylene alkyl ether, and
E is ammonium dodecylbenzenesulfonate.

In the column entitled "Oxidizing agent" of Table 3 to Table 5, H2O2 is hydrogen peroxide.

As shown in Table 3 to Table 5, in Examples 32 to 72, the evaluation with respect to the surface difference levels was good. Among others, in Example 56 and Example 57 where the content of the anticorrosive was from 0.1 to 0.5% by mass, the evaluation with respect to surface difference levels was particularly good. When the object to be polished was a copper blanket wafer, the second polishing compositions in accordance with Example 62 and Example 63 had high polishing rates in comparison with the second polishing compositions in accordance with Example 60 and Example 61. These results suggest that the second polishing composition having a completely saponified polyvinyl alcohol content of 0.05 to 0.5% by mass had ability for polishing the copper-containing metal. When the object to be polished was a copper blanket wafer, the second polishing compositions in accordance with Example 71 and Example 72 had high polishing rates in comparison with the second polishing compositions in accordance with Examples 68 to 70. These results suggest that the second polishing composition having an oxidizing agent content of 2 to 5% by mass had ability for polishing the copper-containing metal.

In order to prepare the first polishing compositions in accordance with Examples 73 to 105 and Comparative Examples 27 to 42, the components shown in Table 6 and Table 7 were mixed with water. The pH values of the first polishing compositions in accordance with Examples 73 to 105 and Comparative Examples 27 to 42 were measured. The results are shown in Table 6 and Table 7.

Copper blanket wafers were polished by using the first polishing compositions in accordance with Examples 73 to105 and Comparative Examples 27 to42 under the first polishing conditions. The copper blanket wafer was prepared by forming a copper layer on an 8 inch silicon wafer by electrolytic plating. The copper blanket wafers before and after the polishing were measured in thickness by using a sheet type resistor machine "VR-120" available from KOKUSAI DENKI SYSTEM SERVICE Co. Ltd. A reduced amount of thickness of the wafer by polishing was calculated from the measured thicknesses of the wafers before and after the polishing. A polishing rate, which was provided by dividing the thus calculated thickness by polishing time, is shown in the column entitled "Polishing rate" of Table 6 and Table 7.

A copper patterned wafer was polished by using a polishing slurry, "PLANERLITE-7102", available from FUJIMI INCORPORATED under the aforementioned second polishing conditions. The copper patterned wafer was a copper patterned wafer with a 1000 nm thick copper layer (854 mask pattern) available from SEMTECH Co. Ltd., and had an initial recess 16 of 800 nm depth. The polishing was terminated at the time when the thickness of the copper layer of the copper patterned wafer after polishing was 70% of the thickness of the copper layer of the copper patterned wafer before polishing. This process corresponds to the chemical mechanical polishing process of the first sub step in the first polishing step. Next, the copper patterned wafer after being subjected to the chemical mechanical polishing process of the first sub step was polished by using each of the first polishing compositions in accordance with Examples 73 to105 and Comparative Examples 27 to42 under the first polishing conditions. The barrier layer 14 thus polished, the upper surface of which was detected to expose itself by an indicating endpoint, was additionally polished for another period of time necessary to polish out a 200 nm thick copper layer, followed by finishing of the polishing. This process corresponds to the chemical mechanical polishing process of the second sub step in the first polishing step. Thereafter, a region with a 100 µm wide wiring 17 formed was measured by using a contact type surface measuring apparatus of profiler, "HRP340", available from KLA-Tencol Co. The results of the measurement are shown in the column entitled "Depth of dishing" of Table 6 and Table 7. In the column, "-" (hyphen) represents the fact that a depth of dishing could not be measured because the wafer was not polished.

With respect to the copper patterned wafer subjected to the chemical mechanical polishing processes of the first sub step and the second sub step, the amount of copper-containing metal left on the region of the insulating layer 12 with no wiring 17 formed was measured. The amount of the copper-containing metal left was measured by using a differential interference microscope, "OPTIPHOT0300", available from NIKON Co. Ltd. On the basis of the thus measured amount of the copper-containing metal left, each of the first polishing compositions in accordance with Examples 73 to 105 and Comparative Examples 27 to 42 was evaluated based on four levels: Excellent (Ⓞ), Good (O), Pass (Δ) and Poor (×). Namely, a case where no copper-containing metal was found left was evaluated as Excellent, a case where copper-containing metal was slightly left was evaluated as Good, a case where spotted copper-containing metal was found left throughout was evaluated as Pass, and a case where too large an amount of the copper-containing metal was found left to confirm wiring was evaluated as Poor. The results of the evaluation are shown in the column entitled "Amount of copper-containing metal left" of Table 6 and Table 7.

The copper blanket wafers were polished under the first polishing conditions by using the first polishing compositions in accordance with Examples 73 to 105 and Comparative Examples 27 to 42 immediately after preparation and the first polishing compositions in accordance with Examples 73 to 105 and Comparative Examples 27 to 42 after storage in a closed container for a while after preparation, respectively. Each polishing rate was calculated from the thicknesses of the wafers before and after the polishing, and on the basis of degree of lowering of polishing rate due to storage of each first polishing composition, the pot life of each of the first polishing compositions in accordance with Examples 73 to 105 and Comparative Examples 27 to 42 was evaluated based on four levels: Excellent (Ⓞ), Good (O), Pass (Δ) and Poor (×). Namely, a case where the polishing rate provided by the first polishing composition stored for two weeks or more was greater than 90% of the polishing rate provided by the first polishing composition immediately after preparation was evaluated as Excellent, a case where the polishing rate provided by the first polishing composition stored for one week or more and less than two weeks was less than 90% of the polishing rate provided by the first polishing composition immediately after preparation was evaluated as Good, a case where the polishing rate provided by the first polishing composition stored for three days or more and less than one week was less than 90% of the polishing rate provided by the first polishing composition immediately after preparation was evaluated as Pass, and a case where the polishing rate provided by the first polishing composition stored for less than three days was less than 90% of the polishing rate provided by the first polishing composition immediately after preparation was evaluated as Poor. The results of the evaluation are shown in the column entitled "Pot life" of Table 6 and Table 7.

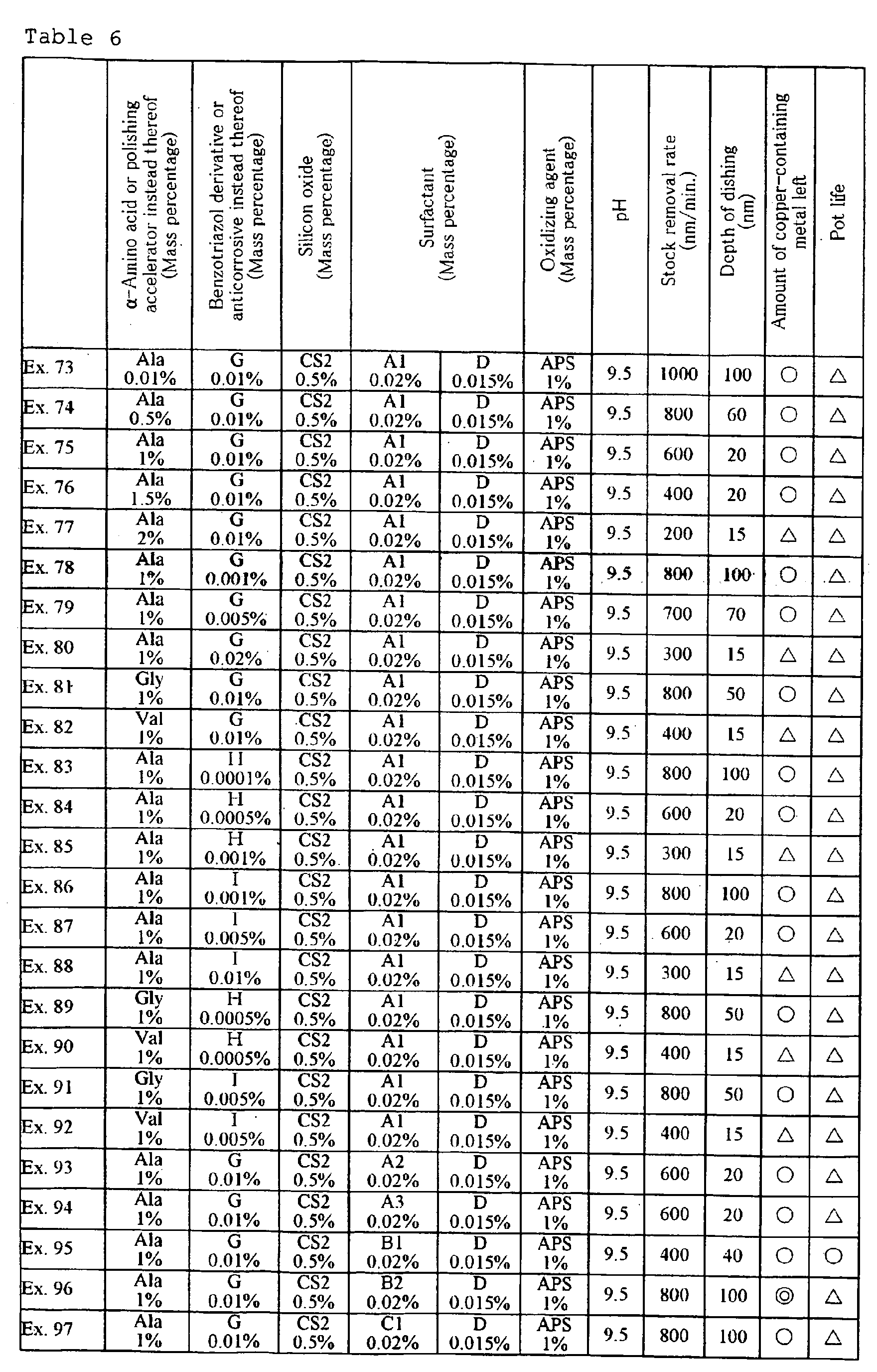

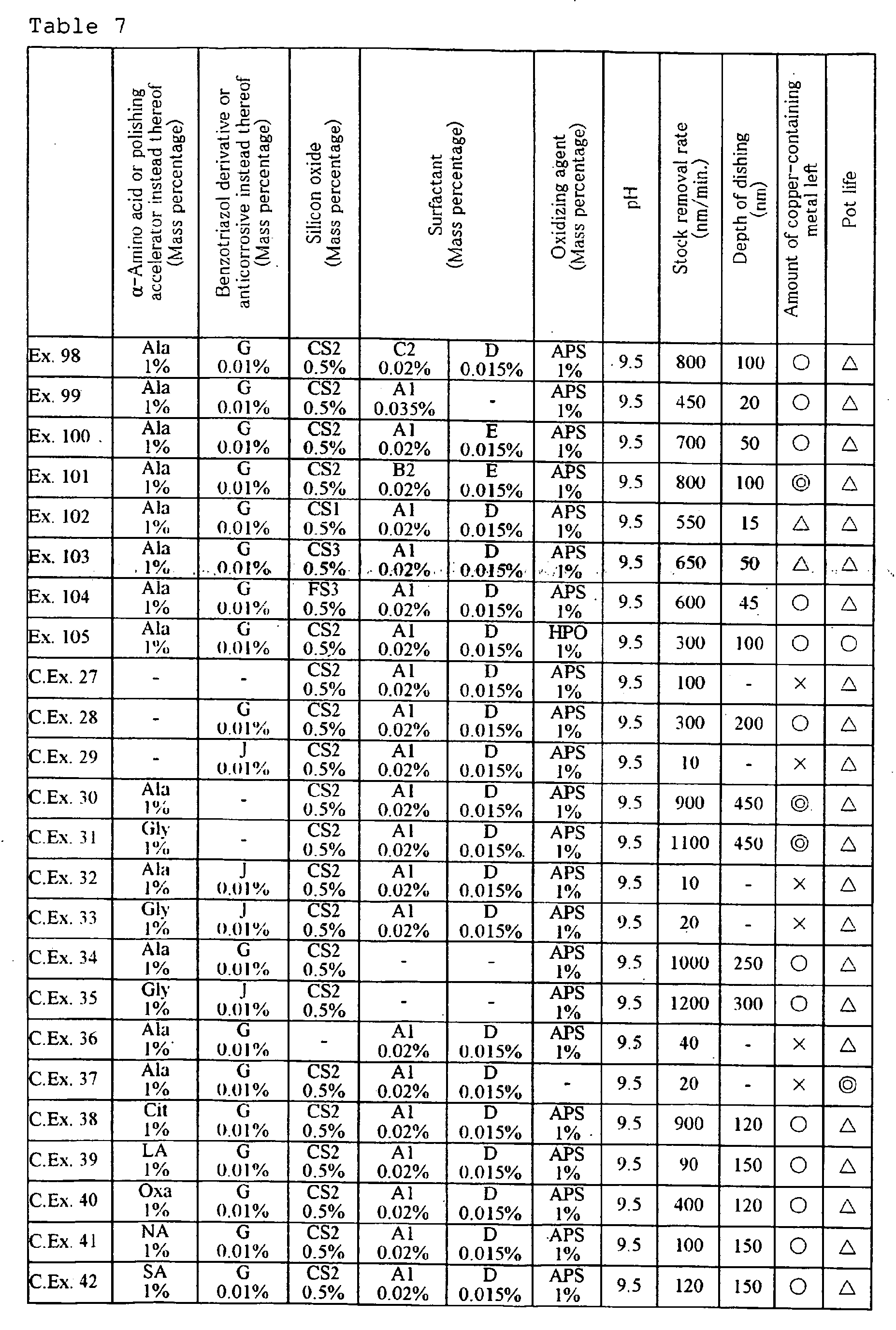

In the column entitled "α-Amino acid or polishing accelerator instead thereof" in Table 6 and Table 7,
Ala is alanine,
Gly is glycine,
Val is valine,
Cit is citric acid,
LA is lactic acid,
Oxa is oxalic acid,
NA is nitric acid, and
SA is sulfuric acid.

In the column entitled "Benzotriazole derivative or anticorrosive instead thereof" in Table 6 and Table 7,
G is 1-(2,3-dihydroxypropyl)benzotriazole,
H is 1-[N,N-bis(hydroxydimethyl)aminomethyl]-benzotriazole,
I is 1-(1,2-dicarboxyethyl)benzotriazole, and
J is benzotriazole.

In the column entitled "Silicon oxide" of Table 6 and Table 7,
CS1 is colloidal silica having an average particle size D_{N4} of 0.03 µm,
CS2 is colloidal silica having an average particle size D_{N4} of 0.05 µm,
CS3 is colloidal silica having an average particle size D_{N4} of 0.07 µm, and
FS3 is a fumed silica having an average particle size D_{N4} of 0.07 µm.

The average particle size D_{N4} of the silicon oxide was measured by using an N4 Plus Submicron Particle Sizer available from Beckman Coulter, Inc. The sum of the amounts of iron, nickel, copper, chromium, zinc and calcium in a 20% by mass aqueous solution of the colloidal silica was not more than 20 ppb.

In the column entitled "Surfactant" of Table 6 and Table 7,
A1 is coconut oil fatty acid sarcosine triethanolamine,
A2 is coconut oil fatty acid methyl taurin sodium,
A3 is sodium polyoxyethylene coconut oil fatty acid monoethanolamide sulfate,
B1 is polyoxyethylene alkyl phenyl ether phosphate,
B2 is dodecylbenzene sulfonic acid triethanolamine,
C1 is disodium polyoxyethylene alkyl sulfosuccinate,
C2 is sulfosuccinic acid salt,
D is polyoxyethylene lauryl ether sulfate triethanolamine, and
E is diisobutyldimethylbutynediol polyoxyethylene glycol ether.

In the column entitled "Oxidizing agent" in Table 6 and Table 7,
APS is ammonium persulfate, and
HPO is hydrogen peroxide.

As shown in Table 6 and Table 7, in Examples 73 to 105, it was found that the depth of dishing was small and the occurrence of dishing was inhibited. Also, it was found that the first polishing compositions of Examples 73 to 105 had high ability for polishing the copper-containing metal.

A copper patterned wafer (854 mask pattern) available from SEMTECH Co. Ltd. was polished by using a polishing slurry, "PLANERLITE-7102", available from FUJIMI INCORPORATED under the aforementioned second polishing conditions. This process corresponds to the chemical mechanical polishing process of the first sub step in the first polishing step. Next, the copper patterned wafer was polished by using the first polishing composition in accordance with Example 75 under the aforementioned first polishing conditions. This process corresponds to the chemical mechanical polishing process of the second sub step in the first polishing step. Subsequently, the copper patterned wafer subjected to the chemical mechanical polishing process of the second sub step was polished by using each of the second polishing compositions in accordance with Examples 32 to 72 and Comparative Examples 12 to 26 under the third polishing conditions. This process corresponds to the chemical mechanical polishing process of the second sub step in the second polishing step. At the end of the second sub step and the end of the second polishing step, a region with 100 µm wiring 17 formed was measured for the depth of dishing. A difference was calculated by measuring the depth of dishing measured at the end of the second polishing step from the depth of dishing measured at the end of the second sub step. The amount of the calculated difference was approximately the same as the amount of calculated difference when the first polishing composition in accordance with Example 2 was used instead of the first polishing composition in accordance with Example 75 in the chemical polishing process of the second sub step.

After cleaning and drying the copper patterned wafer subjected to the chemical mechanical polishing process of the second polishing step as mentioned above, the number of particles having a size of not less than 0.25 µm existing on the wafer was counted. The number of the counted particles was also approximately the same as the number of the counted particles when the first polishing composition in accordance with Example 2 was used instead of the first polishing composition in accordance with Example 75 in the chemical polishing process of the second sub step.

The number of particles corresponding to surface defects among 100 particles randomly selected from the particles on the copper patterned wafer after being cleaned and dried was calculated by percentage. The percentage was also approximately the same as the percentage calculated when the first polishing composition in accordance with Example 2 was used instead of the first polishing composition in accordance with Example 75 in the chemical polishing process of the second sub step.

When the copper patterned wafer subjected to the chemical mechanical polishing processes of the first sub step and the second sub step was polished by using the second polishing composition in accordance with Examples 32 to 72 and Comparative Examples 12 to 26 under the third polishing conditions, the polishing rate was calculated from the thickness of each wafer before and after polishing. The polishing rate was also approximately the same as the polishing rate calculated when the first polishing composition in accordance with Example 2 was used instead of the first polishing composition in accordance with Example 75 in the chemical polishing process of the second sub step.

## Claims

1. A polishing composition for use in polishing for forming wiring in a semiconductor device, the polishing composition **characterized by** containing:
colloidal silica,
an acid,
an anticorrosive,
a completely saponified polyvinyl alcohol, and
water.

2. The polishing composition according to Claim 1, **characterized by** further containing an oxidizing agent.

3. The polishing composition according to Claim 1 or 2, **characterized in that** the colloidal silica has an average particle size of 0.01 to 0.5 µm.

4. The polishing composition according to any one of Claims 1 to 3, **characterized in that** the colloidal silica includes a first colloidal silica having an average particle size of 0.05 µm or more and 0.3 µm or less, and a second colloidal silica having an average particle size of 0.01 µm or more and less than 0.05 µm.

5. The polishing composition according to any one of Claims 1 to 4, **characterized in that** the acid includes at least one kind selected from nitric acid, hydrochloric acid, sulfuric acid, lactic acid, acetic acid, oxalic acid, citric acid, malic acid, succinic acid, butyric acid and malonic acid.

6. A method for polishing an object, the method **characterized by** using the polishing composition according to any one of Claims 1 to 5 in order to form wiring (17) in a semiconductor device.

7. A method for polishing an object to form wiring (17) in a semiconductor device, wherein the object has a barrier layer (14) and a conductive layer (15) in this order on an insulating layer (12) having a trench (13), and the barrier layer and the conductive layer have a portion positioned outside the trench and a portion positioned inside the trench, respectively, the method **characterized by**:
removing the portion of the conductive layer positioned outside the trench and the portion of the barrier layer positioned outside the trench by chemical mechanical polishing using the polishing composition according to any one of Claims 1 to 5 to expose an upper surface of the insulating layer.

8. A method for polishing an object to form wiring (17) in a semiconductor device, wherein the object has a barrier layer (14) and a conductive layer (15) in this order on an insulating layer (12) having a trench (13), and the barrier layer and the conductive layer have a portion positioned outside the trench and a portion positioned inside the trench, respectively, the method **characterized by**:
removing a part of the portion of the conductive layer positioned outside the trench by chemical mechanical polishing to expose an upper surface of the barrier layer, and
removing the remaining part of the portion of the conductive layer positioned outside the trench and the portion of the barrier layer positioned outside the trench by chemical mechanical polishing to expose an upper surface of the insulating layer,
wherein a first polishing composition is used in the chemical mechanical polishing to remove a part of the portion of the conductive layer positioned outside the trench, and a second polishing composition is used in the chemical mechanical polishing to remove the remaining part of the portion of the conductive layer positioned outside the trench and the portion of the barrier layer positioned outside the trench, and
the first polishing composition includes a surfactant, a silicon oxide, a carboxylic acid, an anticorrosive, an oxidizing agent and water, the surfactant including at least one kind selected from the compounds represented by general formulae (1) to (7) and salts thereof;
in the general formula (1), R¹ represents an alkyl group having 8 to 16 carbon atoms, R² represents a hydrogen atom, a methyl group, or an ethyl group, R³ represents an alkylene group having 1 to 8 carbon atoms, - (CH₂CH₂O)ₗ-, - (CH₂CH(CH₃)O)ₘ-, or a combination of at least two kinds thereof, when R³ represents - (CH₂CH₂O)ₗ- or -(CH₂CH(CH₃)O)ₘ-, l and m are an integer of 1 to 8, when R³ represents the combination of - (CH₂CH₂O)ₗ- and -(CH₂CH(CH₃)O)ₘ-, the sum of 1 and m is an integer of 8 or less, X¹ represents a carboxyl group or a sulfone group;
in the general formulae (2) and (3), R⁴ represents an alkyl group having 8 to 16 carbon atoms, Z is a functional group represented by the chemical formula (i) or (ii), Y¹ represents -(CH₂CH₂O)ₙ-, -(CH₂CH(CH₃)O)ₚ-, or a combination of - (CH₂CH₂O)ₙ- and -(CH₂CH(CH₃)O)ₚ-, when Y¹ represents - (CH₂CH₂O)ₙ- or -(CH₂CH(CH₃)O)ₚ-, n and p are an integer of 1 to 6, when Y¹ represents the combination of - (CH₂CH₂O)ₙ- and -(CH₂CH(CH₃)O)ₚ-, sum of n and p is an integer of 6 or less, X² represents a phosphoric acid group or a sulfone group; and
in the general formulae (4) to (7), each of R⁵ and R⁶ represents a hydrogen atom, a hydroxyl group, or an alkyl group having 8 to 16 carbon atoms, each of Y² and Y³ represents -(CH₂CH₂O)_{q}-, - (CH₂CH(CH₃)O)ᵣ-, or a combination of - (CH₂CH₂O)_{q}- and -(CH₂CH(CH₃)O)ᵣ-, when Y² or Y³ represents - (CH₂CH₂O)_{q}- or -(CH₂CH(CH₃)O)ᵣ-, q and r are an integer of 1 to 6, when Y² or Y³ represents the combination of -(CH₂CH₂O)_{q}- and -(CH₂CH(CH₃)O)ᵣ-, the sum of q and r is an integer of 6 or less, and
the second polishing composition is the polishing composition according to any one of Claims 1 to 5. 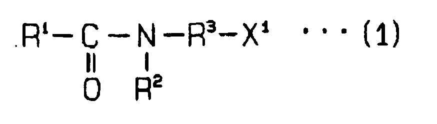
R⁴-Z-Y¹-X² (2)
R⁴-Z-X² (3)

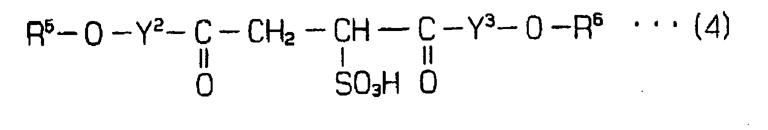

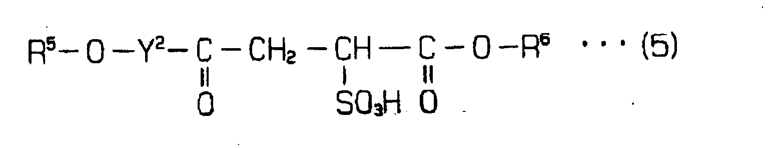

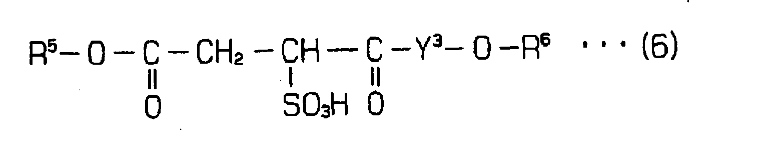

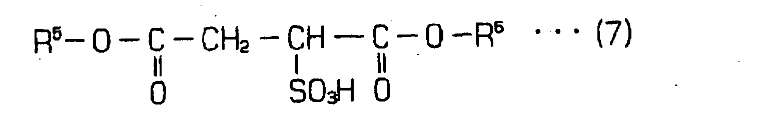

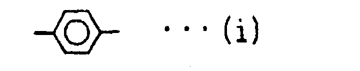

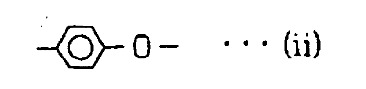

9. The method according to Claim 8, **characterized in that** the carboxylic acid in the first polishing composition is an α-amino acid.

10. The method according to Claim 8 or 9, **characterized in that** the anticorrosive in the first polishing composition is a benzotriazole derivative represented by general formula (8): 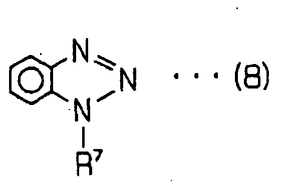 in the general formula (8), R⁷ represents an alkyl group having a carboxyl group, an alkyl group having a hydroxyl group and a tertiary amino group, an alkyl group having a hydroxy group, or an alkyl group other than those.

11. A method for polishing an object to form wiring (17) in a semiconductor device, wherein the object has a barrier layer (14) and a conductive layer (15) in this order on an insulating layer (12) having a trench (13), and the barrier layer and the conductive layer have a portion positioned outside the trench and a portion positioned inside the trench, respectively, the method **characterized by**:
removing a part of the portion of the conductive layer positioned outside the trench by chemical mechanical polishing to expose an upper surface of the barrier layer, and
removing the remaining part of the portion of the conductive layer positioned outside the trench and the portion of the barrier layer positioned outside the trench by chemical mechanical polishing to expose an upper surface of the insulating layer,
wherein a first polishing composition is used in the chemical mechanical polishing to remove a part of the portion of the conductive layer positioned outside the trench, and a second polishing composition is used in the chemical mechanical polishing to remove the remaining part of the portion of the conductive layer positioned outside the trench and the portion of the barrier layer positioned outside the trench,
the first polishing composition includes an α-amino acid, a benzotriazole derivative, a silicon oxide, a surfactant, an oxidizing agent and water, the benzotriazole derivative is represented by general formula (8): 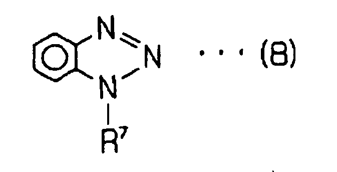 in the general formula (8), R⁷ represents an alkyl group having a carboxyl group, an alkyl group having a hydroxyl group and a tertiary amino group, an alkyl group having a hydroxyl group, or an alkyl group other than those, and
the second polishing composition is the polishing composition according to any one of Claims 1 to 5.

## Patentansprüche

1. Polierzusammensetzung zur Verwendung beim Polieren zum Bilden von Verdrahtungen in einer Halbleitervorrichtung, wobei die Polierzusammensetzung **dadurch gekennzeichnet ist, dass** sie:
kolloidales Silica;
eine Säure,
ein Antikorrosionsmittel,
einen vollständig verseiften Polyvinylalkohol und
Wasser
enthält.

2. Polierzusammensetzung nach Anspruch 1, **dadurch gekennzeichnet, dass** sie ferner ein Oxidationsmittel enthält.

3. Polierzusammensetzung nach Anspruch 1 oder 2, **dadurch gekennzeichnet, dass** das kolloidale Silica eine mittlere Partikelgröße von 0,01 bis 0,5 µm aufweist.

4. Polierzusammensetzung nach einem der Ansprüche 1 bis 3, **dadurch gekennzeichnet, dass** das kolloidale Silica ein erstes kolloidale Silica mit einer mittleren Partikelgröße von 0,05 µm oder mehr und 0,3 µm oder weniger und ein zweites kolloidale Silica mit einer mittleren Partikelgröße von 0,01 µm oder mehr und weniger als 0,05 µm enthält.

5. Polierzusammensetzung nach einem der Ansprüche 1 bis 4, **dadurch gekennzeichnet, dass** die Säure wenigstens eine Art einschließt, die ausgewählt ist aus Salpetersäure, Salzsäure, Schwefelsäure, Milchsäure, Essigsäure, Kleesäure, Zitronensäure, Äpfelsäure, Bernsteinsäure, Buttersäure und Malonsäure.

6. Verfahren zum Polieren eines Gegenstands, wobei das Verfahren **gekennzeichnet ist durch** das Verwenden der Polierzusammensetzung gemäß einem der Ansprüche 1 bis 5 zum Bilden der Verdrahtung (17) in einer Halbleitervorrichtung.

7. Verfahren zum Polieren eines Gegenstands zum Bilden der Verdrahtung (17) in einer Halbleitervorrichtung, wobei der Gegenstand in dieser Reihenfolge eine Barriereschicht (14) und eine leitfähige Schicht (15) auf einer isolierenden Schicht (12) mit einem Graben (13) aufweist und die Barriereschicht und die leitfähige Schicht jeweils einen außerhalb des Grabens angeordneten Teil und einen innerhalb des Grabens angeordneten Teil aufweisen und wobei das Verfahren **gekennzeichnet ist durch**:
Entfernen des außerhalb des Grabens angeordneten Teils der leitfähigen Schicht und des außerhalb des Grabens angeordneten Teils der Barriereschicht **durch** chemisch-mechanisches Polieren unter Verwenden der Polierzusammensetzung gemäß einem der Ansprüche 1 bis 5, um eine Oberfläche der isolierenden Schicht freizulegen.

8. Verfahren zum Polieren eines Gegenstands zum Bilden einer Verdrahtung (17) in einer Halbleitervorrichtung, wobei der Gegenstand in dieser Reihenfolge eine Barriereschicht (14) und eine leitfähige Schicht (15) auf einer isolierenden Schicht (12) mit einem Graben (13) aufweist und die Barriereschicht und die leitfähige Schicht jeweils einen außerhalb des Grabens angeordneten Teil und einen innerhalb des Grabens angeordneten Teil aufweisen und wobei das Verfahren **gekennzeichnet ist durch**:
Entfernen eines Teils des außerhalb des Grabens angeordneten Teils der leitfähigen Schicht **durch** chemisch-mechanisches Polieren, um eine Oberfläche der Barriereschicht freizulegen, und
Entfernen des restlichen Teils des außerhalb des Grabens angeordneten Teils der leitfähigen Schicht und des außerhalb des Grabens angeordneten Teils der Barriereschicht **durch** chemisch-mechanisches Polieren, um eine Oberfläche der isolierenden Schicht freizulegen,
wobei eine erste Polierzusammensetzung während des chemisch-mechanischen Polierens zum Entfernen eines Teils des außerhalb des Grabens angeordneten Teils der leitfähigen Schicht verwendet wird und eine zweite Polierzusammensetzung während des chemisch-mechanischen Polierens zum Entfernen des restlichen Teils des außerhalb des Grabens angeordneten Teils der leitfähigen Schicht und des außerhalb des Grabens angeordneten Teils der Barriereschicht verwendet wird und
die erste Polierzusammensetzung eine oberflächenaktive Substanz, ein Siliziumoxid, eine Carbonsäure, eine Antikorrosionsmittel, ein Oxidationsmittel und Wasser enthält, wobei die oberflächenaktive Substanz wenigstens eine Art einschließt, die ausgewählt ist aus den Verbindungen, die **durch** die allgemeinen Formeln (1) bis (7) wiedergegebenen sind, und Salzen derselben;
wobei in der allgemeinen Formel (1) R¹ eine Alkylgruppe mit 8 bis 16 Kohlenstoffatomen darstellt, R² ein Wasserstoffatom, eine Methylgruppe oder eine Ethylgruppe darstellt, R³ eine Alkylengruppe mit 1 bis 8 Kohlenstoffatomen, -(CH₂CH₂O)ₗ-, -(CH₂CH(CH₃)O)ₘ- oder eine Kombination von wenigstens zwei dieser Arten darstellt, wobei, wenn R³ -(CH₂CH₂O)ₗ-oder -(CH₂CH(CH₃)O)ₘ-darstellt, 1 und m eine ganze Zahl von 1 bis 8 sind, und, wenn R³ die Kombination von -(CH₂CH₂O)₁-und -(CH₂CH(CH₃)O)ₘ- darstellt, die Summe von 1 und m eine ganze Zahle von 8 oder weniger ist, X¹ eine Carbonsäuregruppe oder eine Sulfonsäuregruppe darstellt;
wobei in den allgemeinen Formel (2) und (3) R⁴ eine Alkylgruppe mit 8 bis 16 Kohlenstoffatomen darstellt, Z eine funktionelle Gruppe ist, die **durch** die chemische (i) oder (ii) dargestellt ist, Y¹ -(CH₂CH₂O)ₙ-, -(CH₂CH(CH₃O)ₚ- oder eine Kombination von -(CH₂CH₂O)ₙ- und -(CH₂CH(CH₃)O)ₚ- darstellt, wobei, wenn Y¹-(CH₂CH₂O)ₙ- oder -(CH₂CH(CH₃)O)ₚ- darstellt, n und p eine ganze Zahl von 1 bis 6 sind, und, wenn Y¹ die Kombination von -(CH₂CH₂O)ₙ- und -(CH₂CH(CH₃)O)ₚ-darstellt, die Summe von n und p eine ganze Zahl von 6 oder weniger ist, X² eine Phosphorsäuregruppe oder eine Sulfonsäuregruppe darstellt; und
wobei in den allgemeinen Formeln (4) bis (7) R⁵ und R⁶ jeweils ein Wasserstoffatom, eine Hydroxylgruppe oder eine Alkylgruppe mit 8 bis 16 Kohlenstoffatomen darstellen, Y² und Y³ jeweils -(CH₂CH₂O)_{q}-, -(CH₂CH(CH₃)O)ᵣ oder eine Kombination von -(CH₂CH₂O)_{q} und -(CH₂CH(CH₃)O)ᵣ darstellen, wobei, wenn Y² oder Y³ -(CH₂CH₂O)_{q} oder -(CH₂CH(CH₃)O)ᵣ darstellen, q und r eine ganze Zahl von 1 bis 6 sind, und, wenn Y² oder Y³ die Kombination von -(CH₂CH₂O)_{q} und -(CH₂CH(CH₃)O)ᵣ darstellen, die Summe von q und r eine ganze Zahl von 6 oder weniger ist, und
wobei die zweite Polierzusammensetzung die Polierzusammensetzung gemäß einem der Ansprüche 1 bis 5 ist. 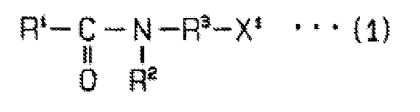
R⁴-Z-Y¹-X² (2)
R⁴-Z-X^{a} (3)

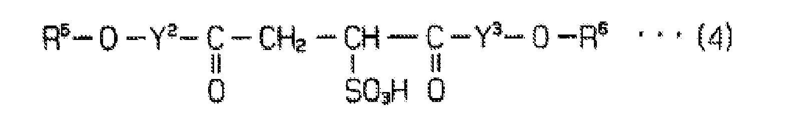

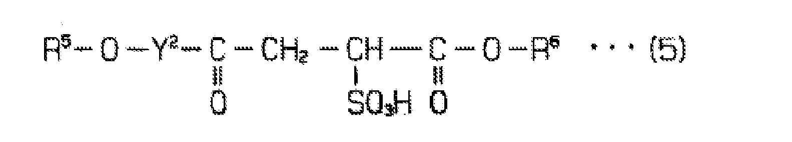

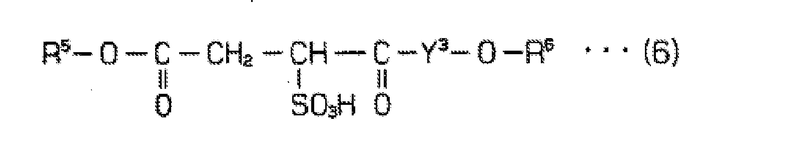

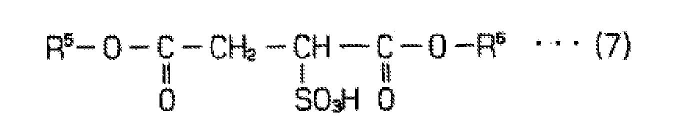

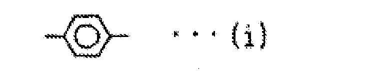

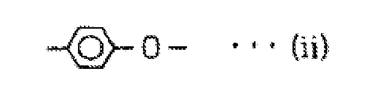

9. Verfahren nach Anspruch 8, **dadurch gekennzeichnet, dass** die Carbonsäure in der ersten Polierzusammensetzung eine α-Aminosäure ist.

10. Verfahren nach Anspruch 8 oder 9, **dadurch gekennzeichnet, dass** das Antikorrosionsmittel in der ersten Polierzusammensetzung ein Benzotriazolderivat ist, das durch die allgemeine Formel (8) wiedergegeben ist: 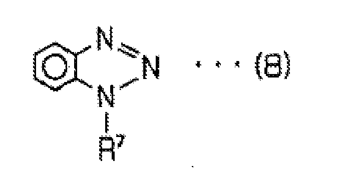 wobei in der allgemeinen Formel (8) R⁷ eine Alkylgruppe mit einer Carbonsäuregruppe, eine Alkylgruppe mit einer Hydroxylgruppe und einer tertiären Aminogruppe, eine Alkylgruppe mit einer Hydroxylgruppe oder eine andere Alkylgruppe als die hier angegebenen darstellt.

11. Verfahren zum Polieren eines Gegenstands zum Bilden einer Verdrahtung (17) in einer Halbleitervorrichtung, wobei der Gegenstand in dieser Reihenfolge eine Barriereschicht (14) und eine leitfähige Schicht (15) auf einer isolierenden Schicht (12) mit einem Graben (13) aufweist und die Barriereschicht und die leitfähige Schicht jeweils einen außerhalb des Grabens angeordneten Teil und einen innerhalb des Grabens angeordneten Teil aufweisen und wobei das Verfahren **gekennzeichnet ist durch**:
Entfernen eines Teils des außerhalb des Grabens angeordneten Teils der leitfähigen Schicht **durch** chemisch-mechanisches Polieren, um eine Oberfläche der Barriereschicht freizulegen, und
Entfernen des restlichen Teils des außerhalb des Grabens angeordneten Teils der leitfähigen Schicht und des außerhalb des Grabens angeordneten Teils der Barriereschicht **durch** chemisch-mechanisches Polieren, um eine Oberfläche der isolierenden Schicht freizulegen,
wobei eine erste Polierzusammensetzung während des chemisch-mechanischen Polierens zum Entfernen eines Teils des außerhalb des Grabens angeordneten Teils der leitfähigen Schicht verwendet wird und eine zweite Polierzusammensetzung während des chemisch-mechanischen Polierens zum Entfernen des restlichen Teils des außerhalb des Grabens angeordneten Teils der leitfähigen Schicht und des außerhalb des Grabens angeordneten Teils der Barriereschicht verwendet wird und
die erste Polierzusammensetzung eine α-Aminosäure, ein Benzotriazolderivat, ein Siliziumoxid, eine oberflächenaktive Substanz, ein Oxidationsmittel und Wasser enthält, wobei das Benzotriazolderivat **durch** die allgemeine Formel (8) wiedergegeben ist: 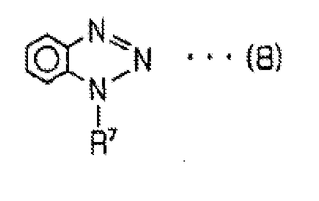 wobei in der allgemeinen Formel (8) R⁷ eine Alkylgruppe mit einer Carbonsäuregruppe, eine Alkylgruppe mit einer Hydroxylgruppe und einer tertiären Aminogruppe, eine Alkylgruppe mit einer Hydroxylgruppe oder eine andere Alkylgruppe als die hier angegebenen darstellt, und
die zweite Polierzusammensetzung die Polierzusammensetzung gemäß einem der Ansprüche 1 bis 5 ist.

## Revendications

1. Composition de polissage pour l'utilisation en polissage pour former un câblage électrique dans un dispositif semiconducteur, la composition de polissage étant **caractérisée en ce qu'**elle contient :
de la silice colloïdale,
un acide,
un anticorrosif,
un alcool polyvinylique complètement saponifié, et
de l'eau.

2. Composition de polissage selon la revendication 1, **caractérisée en ce qu'**elle contient en outre un agent oxydant.

3. Composition de polissage selon la revendication 1 ou 2, **caractérisée en ce que** la silice colloïdale a une taille moyenne de particule de 0,01 à 0,5 µm.

4. Composition de polissage selon l'une quelconque des revendications 1 à 3, **caractérisée en ce que** la silice colloïdale inclut une première silice colloïdale ayant une taille moyenne de particule de 0,05 µm ou plus et de 0,3 µm ou moins, et une seconde silice colloïdale ayant une taille moyenne de particule de 0,01 µm ou plus et de moins de 0,05 µm.

5. Composition de polissage selon l'une quelconque des revendications 1 à 4, **caractérisée en ce que** l'acide inclut au moins une sorte d'acide choisi parmi l'acide nitrique, l'acide chlorhydrique, l'acide sulfurique, l'acide lactique, l'acide acétique, l'acide oxalique, l'acide citrique, l'acide malique, l'acide succinique, l'acide butyrique et l'acide malonique.

6. Procédé pour polir un objet, le procédé étant **caractérisé en ce qu'**il utilise la composition de polissage selon l'une quelconque des revendications 1 à 5 afin de former un câblage (17) dans un dispositif semiconducteur.

7. Procédé pour polir un objet pour former un câblage (17) dans un dispositif semiconducteur, dans lequel l'objet a une couche formant barrière (14) et une couche conductrice (15) dans cet ordre sur une couche isolante (12) comportant une tranchée (13), et la couche formant barrière et la couche conductrice ont, respectivement, une portion située à l'extérieur de la tranchée et une portion située à l'intérieur de la tranchée, le procédé étant **caractérisé par** :
l'élimination de la portion de la couche conductrice située à l'extérieur de la tranchée et de la portion de la couche formant barrière située à l'extérieur de la tranchée par polissage mécanique chimique en utilisant la composition de polissage selon l'une quelconque des revendications 1 à 5 pour exposer une surface supérieure de la couche isolante.

8. Procédé pour polir un objet pour former un câblage (17) dans un dispositif semiconducteur, dans lequel l'objet a une couche formant barrière (14) et une couche conductrice (15) dans cet ordre sur une couche isolante (12) comportant une tranchée (13), et la couche formant barrière et la couche conductrice ont, respectivement, une portion située à l'extérieur de la tranchée et une portion située à l'intérieur de la tranchée, le procédé étant **caractérisé par** :
l'élimination d'une partie de la portion de la couche conductrice située à l'extérieur de la tranchée par polissage mécanique chimique pour exposer une surface supérieure de la couche formant barrière, et
l'élimination de la partie restante de la portion de la couche conductrice située à l'extérieur de la tranchée et de la portion de la couche formant barrière située à l'extérieur de la tranchée par polissage mécanique chimique pour exposer une surface supérieure de la couche isolante,
dans lequel une première composition de polissage est utilisée dans le polissage mécanique chimique pour enlever une partie de la portion de la couche conductrice située à l'extérieur de la tranchée, et une seconde composition de polissage est utilisée dans le polissage mécanique chimique pour enlever la partie restante de la portion de la couche conductrice située à l'extérieur de la tranchée et la portion de la couche formant barrière située à l'extérieur de la tranchée, et
la première composition de polissage comprend un tensioactif, un oxyde de silicium, un acide carboxylique, un anticorrosif, un agent oxydant et de l'eau, le tensioactif incluant au moins une sorte de composé sélectionné parmi les composés représentés par les formules générales (1) à (7) et les sels de ceux-ci ;
dans la formule générale (1), R¹ représente un groupe alkyle ayant 8 à 16 atomes de carbone, R² représente un atome d'hydrogène, un groupe méthyle, ou un groupe éthyle, R³ représente un groupe alkylène ayant 1 à 8 atomes de carbone, - (CH₂CH₂O)ₗ-, -(CH₂CH(CH₃)O)ₘ-, ou un combinaison d'au moins deux sortes de ceux-ci, lorsque R³ représente -(CH₂CH₂O)ₗ- ou -(CH₂CH(CH₃)O)ₘ-, l et m sont un nombre entier de 1 à 8, lorsque R³ représente la combinaison de -(CH₂CH₂O)ₗ- et - (CH₂CH(CH₃)O)ₘ-, la somme de 1 et m est un nombre entier valant 8 ou moins, X¹ représente un groupe carboxyle ou un groupe sulfone ;
dans les formules générales (2) et (3), R⁴ représente un groupe alkyle ayant 8 à 16 atomes de carbone, Z est un groupe fonctionnel représenté par la formule chimique (i) ou (ii), Y¹ représente -(CH₂CH₂O)ₙ, -(CH₂CH(CH₃)O)ₚ-, ou une combinaison de - (CH₂CH₂O)ₙ et -(CH₂CH(CH₃)O)ₚ-, lorsque Y¹ représente -(CH₂CH₂O)ₙ ou - (CH₂CH(CH₃)O)ₚ-, n et p sont un nombre entier compris entre 1 et 6, lorsque Y¹ représente la combinaison de -(CH₂CH₂O)ₙ- et -(CH₂CH(CH₃)O)ₚ-, la somme de n et p est un nombre entier valant 6 ou moins, X² représente un groupe acide phosphorique ou un groupe sulfone ; et
dans les formules générales (4) à (7), chacun parmi R⁵ et R⁶ représente un atome d'hydrogène, un groupe hydroxyle, ou un groupe alkyle ayant 8 à 16 atomes de carbone, chacun parmi Y² et Y³ représente -(CH₂CH₂O)_{q}-, -(CH₂CH(CH₃)O)ᵣ-, ou une combinaison de -(CH₂CH₂O)_{q} et -(CH₂CH(CH₃)O)ᵣ-, lorsque Y² ou Y³ représente - (CH₂CH₂O)_{q} ou -(CH₂CH(CH₃)O)ᵣ-, q et r sont un nombre entier compris entre 1 et 6, lorsque Y² ou Y³ représente la combinaison de -(CH₂CH₂O)_{q} et -(CH₂CH(CH₃)O)ᵣ-, la somme de q et r est un nombre entier valant 6 ou moins, et
la seconde composition de polissage est la composition de polissage selon l'une quelconque des revendications 1 à 5. 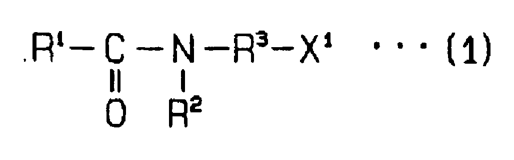
R⁴-Z-Y¹-X² (2)
R⁴-Z-X² (3)

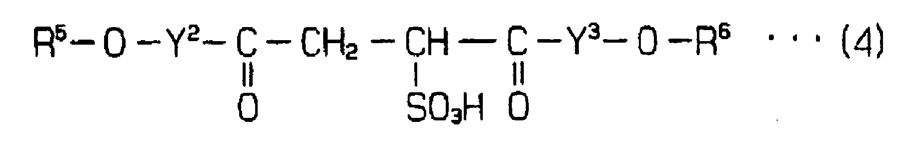

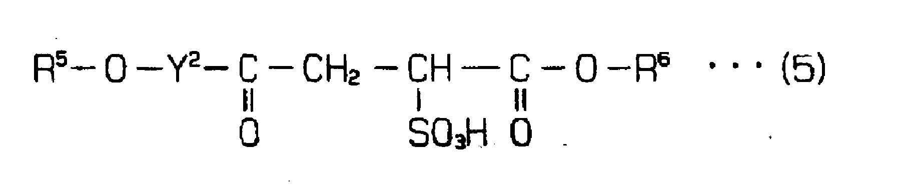

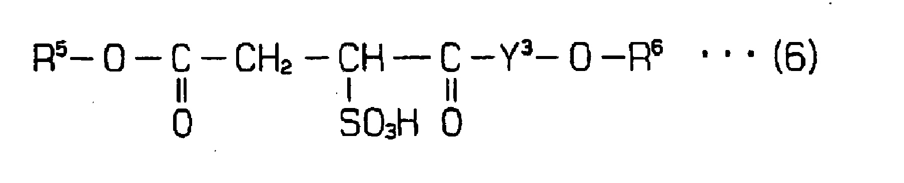

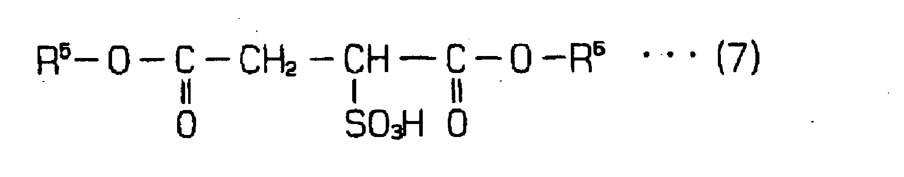

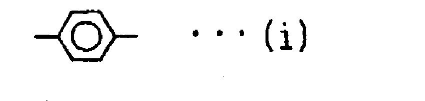

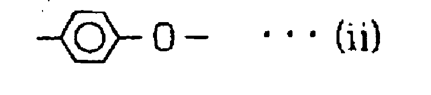

9. Procédé selon la revendication 8, **caractérisé en ce que** l'acide carboxylique dans la première composition de polissage est un acide α-amino.

10. Procédé selon la revendication 8 ou 9, **caractérisé en ce que** l'anticorrosif dans la première composition de polissage est un dérivé benzotriazole représenté par la formule générale (8) : 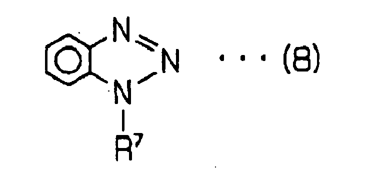 dans la formule générale (8), R⁷ représente un groupe alkyle ayant un groupe carboxyle, un groupe alkyle ayant un groupe hydroxyle et un groupe amino tertiaire, un groupe alkyle ayant un groupe hydroxy, ou un groupe alkyle autre que ceux-ci.

11. Procédé pour polir un objet pour former un câblage (17) dans un dispositif semiconducteur, dans lequel l'objet a une couche formant barrière (14) et une couche conductrice (15) dans cet ordre sur une couche isolante (12) comportant une tranchée (13), et la couche formant barrière et la couche conductrice ont, respectivement, une portion située à l'extérieur de la tranchée et une portion située à l'intérieur de la tranchée, le procédé étant **caractérisé par** :
l'élimination d'une partie de la portion de la couche conductrice située à l'extérieur de la tranchée par polissage mécanique chimique pour exposer une surface supérieure de la couche formant barrière, et
l'élimination de la partie restante de la portion de la couche conductrice située à l'extérieur de la tranchée et de la portion de la couche formant barrière située à l'extérieur de la tranchée par polissage mécanique chimique pour exposer une surface supérieure de la couche isolante,
dans lequel une première composition de polissage est utilisée dans le polissage mécanique chimique pour enlever une partie de la portion de la couche conductrice située à l'extérieur de la tranchée, et une seconde composition de polissage est utilisée dans le polissage mécanique chimique pour enlever la partie restante de la portion de la couche conductrice située à l'extérieur de la tranchée et la portion de la couche formant barrière située à l'extérieur de la tranchée,
la première composition de polissage inclut un acide α-amino, un dérivé benzotriazole, un oxyde de silicium, un tensioactif, un agent oxydant et de l'eau, le dérivé benzotriazole est représenté par la formule générale (8) : 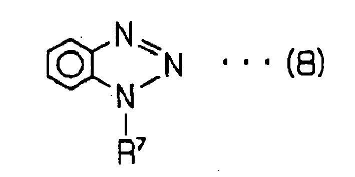 dans la formule générale (8), R⁷ représente un groupe alkyle ayant un groupe carboxyle, un groupe alkyle ayant un groupe hydroxyle et un groupe amino tertiaire, un groupe alkyle ayant un groupe hydroxyle, ou un groupe alkyle autre que ceux-ci, et
la seconde composition de polissage est la composition de polissage selon l'une quelconque des revendications 1 à 5.
